(19) Europäisches Patentamt / European Patent Office / Office européen des brevets

(11) **EP 2 979 788 A1**

(12) **EUROPEAN PATENT APPLICATION**
published in accordance with Art. 153(4) EPC

(43) Date of publication:
**03.02.2016 Bulletin 2016/05**

(51) Int Cl.:
*B23B 27/14* (2006.01)  *B23B 27/20* (2006.01)
*C23C 14/06* (2006.01)

(21) Application number: **14775614.2**

(86) International application number:
**PCT/JP2014/054685**

(22) Date of filing: **26.02.2014**

(87) International publication number:
**WO 2014/156447 (02.10.2014 Gazette 2014/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **29.03.2013 JP 2013073493**

(71) Applicant: **Sumitomo Electric Hardmetal Corp.**
**Itami-shi, Hyogo 664-0016 (JP)**

(72) Inventors:
• **SETOYAMA, Makoto**
  **Itami-shi**
  **Hyogo 664-0016 (JP)**

• **OKAMURA, Katsumi**
  **Itami-shi**
  **Hyogo 664-0016 (JP)**
• **TSUKIHARA, Nozomi**
  **Itami-shi**
  **Hyogo 664-0016 (JP)**

(74) Representative: **Grünecker Patent- und Rechtsanwälte**
**PartG mbB**
**Leopoldstraße 4**
**80802 München (DE)**

(54) **SURFACE-COATED BORON NITRIDE SINTERED TOOL**

(57) In a surface-coated boron nitride sintered body tool, at least a cutting edge portion contains a cubic boron nitride sintered body and a coating layer (10) formed on a surface of the cubic boron nitride sintered body. A layer B (30) of the coating layer (10) is formed by alternately laminating one or more layers of each of two or more thin-film layers (31, 32) having different compositions. AB1 thin-film layer (31) as one of the thin-film layers is formed by alternately laminating one or more layers of each of two or more compound layers (31A, 31B) having different compositions. Each of the compound layers (31A, 31B) has a thickness not less than 0.5 nm and less than 30 nm. A B2 thin-film layer (32) as one of the thin-film layers different from the B1 thin-film layer (31) has a thickness more than 30 nm and less than 200 nm.

FIG.2

**Description**

TECHNICAL FIELD

The present invention relates to a surface-coated boron nitride sintered body tool in which at least a cutting edge portion contains a cubic boron nitride sintered body and a coating layer formed on a surface of the cubic boron nitride sintered body.

BACKGROUND ART

Tools in which the surface of a cubic boron nitride sintered body is coated with a coating layer of a ceramic material or the like exhibit excellent wear resistance, and thus, are used as cutting tools for cutting hardened steel. In recent years, high precision is demanded in such cutting, and improvement of the surface roughness of a workpiece surface is required.

In order to meet this demand, WO 2010/150335 (PTD1) and WO 2012/005275 (PTD2), for example, propose tools in which the surface of a cubic boron nitride sintered body is coated with a coating film, wherein the coating film is composed of a lower layer made of multiple layers of a specific ceramic composition and an upper layer made of compound layers.

Furthermore, as a base material of such a tool coated with multiple layers, cemented carbide, for example, is also used in place of the cubic boron nitride sintered body (Japanese Patent Laying-Open No. 2008-188689 (PTD 3) and Japanese National Patent Publication No. 2008-534297 (PTD4)).

CITATION LIST

PATENT DOCUMENT

PTD 1: WO 2010/150335
PTD 2: WO 2012/005275
PTD 3: Japanese Patent Laying-Open No. 2008-188689
PTD 4: Japanese National Patent Publication No. 2008-534297

SUMMARY OF INVENTION

TECHNICAL PROBLEM

It is known that wear resistance is improved by using, as a cutting tool for machining steel, a tool in which the surface of a base material made of cemented carbide is coated with multiple layers of a ceramic composition. In the case of machining hardened steel, however, wear resistance has not been improved even though the surface of the cutting tool for use in this application that employs the cubic boron nitride sintered body as the base material is coated with multiple layers of a ceramic composition. Further improvement of the surface roughness of a workpiece surface is also demanded. For example, improvement of the surface roughness of a workpiece surface is demanded also in the case of machining or the like of hardened steel in an environment having low equipment rigidity, low workpiece rigidity, or the like.

The present invention was made in view of such circumstances, and an object of the invention is to suppress boundary wear at an end cutting edge portion of a tool in which at least a cutting edge portion includes a base material made of a cubic boron nitride sintered body, in the case of machining or the like of hardened steel, particularly in an environment having low equipment rigidity, low workpiece rigidity, or the like, so as to enhance the tool performance even in high-precision machining using the surface roughness of a workpiece as a criterion of determining the life of the surface-coated boron nitride sintered body tool.

SOLUTION TO PROBLEM

In order to solve the aforementioned problem, the present inventor investigated the condition of wear of a tool that occurs when machining hardened steel. Consequently, it was revealed that in addition to usual crater wear and flank-face wear, boundary wear occurs at the boundary of an end cutting edge, which is one end of wear portions, and this boundary wear most significantly affects tool life. In particular, it was revealed that in the case of machining or the like of hardened steel in an environment having low equipment rigidity, low workpiece rigidity, or the like, a portion brought into contact with the workpiece experiences slight vibrations, which causes minute cracks in the coating layer of the tool, and as a consequence, boundary wear proceeds along with chipping at the boundary of the end cutting edge.

As a result of extensive research based on this finding, the present inventor also found that in order to suppress this boundary wear, it is most effective to laminate layers of specific compositions in a specifically laminated manner, and conducted further research based on this finding to complete the present invention.

In a surface-coated boron nitride sintered body tool according to the invention, at least a cutting edge portion includes a cubic boron nitride sintered body and a coating layer formed on a surface of the cubic boron nitride sintered body. The cubic boron nitride sintered body contains not less than 30% and not more than 80% by volume of the cubic boron nitride, and also includes a binder phase containing an aluminum compound, an inevitable impurity, and at least one compound selected from the group consisting of a nitride, a carbide, a boride, and an oxide of a group 4 element, a group 5 element, and a group 6 element of a periodic table of elements, as well as a solid solution thereof. The coating layer includes a layer A and a layer B. Layer A is composed of $MLa_{za1}$, where M represents one or more of Al, Si, as well as a group 4 element, a group 5 element, and a group 6 element of the periodic table of the elements; La represents one or more of B, C, N, and O; and $za1$ is not less than 0.85 and not more than 1.0. Layer B is formed by alternately laminating one or more layers of each of two or more thin-film layers having different compositions. Each of the thin-film layers has a thickness more than 30 nm and less than 200 nm. A B1 thin-film layer as one of the thin-film layers is formed by alternately laminating one or more layers of each of two or more compound layers having different compositions. Each of the compound layers has a thickness not less than 0.5 nm and less than 30 nm. A B1a compound layer as one of the compound layers is composed of $(Ti_{1-xb1-yb1}Sl_{xb1}M1_{yb1})(C_{1-zb1}N_{zb1})$, where M1 represents one or more of A1 as well as a group 4 element, a group 5 element, and a group 6 element of the periodic table of the elements except for Ti; $xb1$ is not less than 0.01 and not more than 0.25; $yb1$ is not less than 0 and not more than 0.7; and $zb1$ is not less than 0.4 and not more than 1. A B1b compound layer as one of the compound layers different from the B1a compound layer is composed of $(Al_{1-xb2}M2_{xb2})(C_{1-zb2}N_{zb2})$, where M2 represents one or more of Si as well as a group 4 element, a group 5 element, and a group 6 element of the periodic table of the elements; $xb2$ is not less than 0.2 and not more than 0.77; and $zb2$ is not less than 0.4 and not more than 1. A B2 thin-film layer as one of the thin-film layers different from the B 1 thin-film layer is composed of $(Al_{1-xb3}M3_{xb3})(C_{1-zb3}N_{zb3})$, where M3 represents one or more of Si as well as a group 4 element, a group 5 element, and a group 6 element of the periodic table of the elements; $xb3$ is not less than 0.2 and not more than 0.77; and $zb3$ is not less than 0.4 and not more than 1. Layer A has a thickness not less than 0.2 $\mu$m and not more than 10 $\mu$m. Layer B has a thickness not less than 0.06 $\mu$m and not more than 5 $\mu$m. The coating layer has an overall thickness not less than 0.26 $\mu$m and not more than 15 $\mu$m.

ADVANTAGEOUS EFFECTS OF INVENTION

According to the invention, in the case of machining or the like of hardened steel, particularly in an environment having low equipment rigidity, low workpiece rigidity, or the like, boundary wear at an end cutting edge portion can be suppressed to enhance the tool performance even in high-precision machining using the surface roughness of a workpiece as a criterion of determining the life of a surface-coated boron nitride sintered body tool.

BRIEF DESCRIPTION OF DRAWINGS

Fig. 1 is a cross-sectional view showing one exemplary structure of a surface-coated boron nitride sintered body tool according to an example of the invention.
Fig. 2 is a cross-sectional view showing one exemplary structure of a principal part of the surface-coated boron nitride sintered body tool according to an example of the invention.

DESCRIPTION OF EMBODIMENTS

The present invention will be described in further detail below. In the following description of embodiments, the description is given in conjunction with the drawings, in which the same reference numerals represent the same or corresponding elements.

<Structure of Surface-Coated Boron Nitride Sintered Body Tool>

At least a cutting edge portion of a surface-coated boron nitride sintered body tool according to the invention includes a cubic boron nitride sintered body (hereinafter denoted as the "cBN sintered body"; the term "cBN" is an abbreviation of "cubic Boron Nitride") and a coating layer formed on the surface of the cBN sintered body. The surface-coated boron nitride sintered body tool having such a basic structure can be effectively used particularly for mechanically machining (cutting, for example) sintered alloys and difficult-to-machine cast iron, or for machining hardened steel, and additionally can be suitably used for various types of machining of general metals other than the above.

<cBN Sintered Body>

Of the cutting edge portion of the surface-coated boron nitride sintered body tool, the cBN sintered body constitutes a base material of the tool, contains not less than 30% and not more than 80% by volume of cubic boron nitride (hereinafter denoted as "cBN"), and also includes a binder phase. As used herein, the binder phase contains an aluminum compound, an inevitable impurity, and at least one compound selected from the group consisting of a nitride, a carbide, a boride, and an oxide of a group 4 element, a group 5 element, and a group 6 element of the periodic table of the elements, as well as a solid solution thereof. The binder phase binds cBN together. When the cBN sintered body contains not less than 30% by volume of cBN, the wear resistance of the base material of the surface-coated boron nitride sintered body tool can be prevented from decreasing. Furthermore, when the cBN sintered body contains not more than 80% by volume of cBN, cBN can be dispersed in the cBN sintered body, which allows bonding strength of cBN attributed to the binder phase to be ensured. The volume content of cBN is herein determined in accordance with the following method. The cBN sintered body is mirror polished, and then a reflection electron image of the structure of a given region of the cBN sintered body is obtained with an electron microscope at 2000 times magnification. At this time, a particle made of cBN (hereinafter denoted as the "cBN particle") is indicated in a black region, and the binder phase is indicated in a grey or white region. From the obtained image of the cBN sintered body structure, the cBN sintered body region and the binder phase region are binarized by image processing to determine the occupancy area of the cBN particles. The volume content of cBN can be determined by substituting the determined occupancy area of the cBN particles into the following equation:

$$(\text{volume content of cBN}) = (\text{occupancy area of cBN particles}) / (\text{photographed area of cBN sintered body structure}) \times 100.$$

Preferably, the cBN sintered body contains not less than 50% and not more than 65% by volume of cBN. When the cBN sintered body contains not less than 50% by volume of cBN, a base material of the surface-coated boron nitride sintered body tool having an excellent balance between wear resistance and defect resistance can be provided. Furthermore, when the cBN sintered body contains not more than 65% by volume of cBN, the bonding strength of cBN attributed to the binder phase can be increased.

Preferably, at an interface between the cBN sintered body and the coating layer, the cBN particles protrude more toward the coating layer than the binder phase. This allows the adhesion between the cBN sintered body and the coating layer to be increased. More preferably, there is a difference in level of not less than 0.05 $\mu$m and not more than 1.0 $\mu$m between the cBN particles and the binder phase. When this difference in level is not less than 0.05 $\mu$m, an anchor effect can be achieved. Furthermore, when this difference in level is not more than 1.0 $\mu$m, the cBN particles can be prevented from falling off from the cBN sintered body. More preferably, there is a difference in level of not less than 0.1 $\mu$m and not more than 0.5 $\mu$m between the cBN particles and the binder phase. When this difference in level is not less than 0.1 $\mu$m, an anchor effect can be effectively achieved. Furthermore, when this difference in level is not more than 0.5 $\mu$m, the cBN particles can be further prevented from falling off from the cBN sintered body. The difference in level is herein measured in accordance with the same method as the method for measuring the overall thickness of the coating layer and the like described below.

Preferably, the volume content of cBN in the cBN sintered body increases toward the inside of the cBN sintered body from the interface between the cBN sintered body and the coating layer. Thus, at the interface between the cBN sintered body and the coating layer, the volume content of the binder phase is higher than that of cBN, which allows the adhesion between the cBN sintered body and the coating layer to be increased. On the other hand, inside the cBN sintered body, the volume content of cBN is higher than that of the binder phase, which allows the defect resistance of the cBN sintered body to be improved. For example, the volume content of cBN is 40% near the interface to the coating layer (a region not less than 0 $\mu$m and not more than 20 $\mu$m distant from the interface between the cBN sintered body and the coating layer toward the inside of the cBN sintered body). Around the center of the cBN sintered body in a thickness direction (a region more than 20 $\mu$m and not more than 100 $\mu$m distant from the interface between the cBN sintered body and the coating layer toward the inside of the cBN sintered body), the volume content of cBN is 60%.

Preferably, the particle size of the cBN particles contained in the cBN sintered body increases toward the inside of the cBN sintered body from the interface between the cBN sintered body and the coating layer. Thus, at the interface between the cBN sintered body and the coating layer, the particle size of the cBN particles is small, which allows the adhesion between the cBN sintered body and the coating layer to be increased. On the other hand, inside the cBN sintered body, the particle size of the cBN particles is large, which allows toughness to be increased. For example, the particle size of the cBN particles is not less than 0.1 $\mu$m and not more than 1 $\mu$m in the region not less than 0 $\mu$m and not more than 20 $\mu$m distant from the interface between the cBN sintered body and the coating layer toward the inside of the cBN sintered body. The particle size of the cBN particles is not less than 2 $\mu$m and not more than 10 $\mu$m in a region more than 20 $\mu$m and not more than 300 $\mu$m distant from the interface between the cBN sintered body and the coating layer toward the inside of the cBN sintered body. The particle size of the cBN particles is herein determined in accordance with the following method. In the reflection electron image of the cBN sintered body structure obtained in determining the volume content of cBN, the diameter of a circle that circumscribes a cBN particle is measured, and the measured diameter is determined as the particle size of the cBN particle.

It is noted that the cBN sintered body may be provided in the cutting edge portion of the surface-coated boron nitride sintered body tool. Therefore, the base material of the surface-coated boron nitride sintered body tool may include a cutting edge portion made of the cBN sintered body, and a base material body made of a material different from the cBN sintered body (cemented carbide, for example). In this case, the cutting edge portion made of the cBN sintered body is preferably adhered to the base material body with a braze material or the like interposed therebetween. The braze material can be selected in consideration of the bonding strength or the melting point. The cBN sintered body may also constitute the entire base material of the surface-coated boron nitride sintered body tool.

<Coating Layer>

The coating layer includes layer A and layer B. As long as the coating layer of the invention includes layer A and layer B, it may include other layers in addition to layers A and B. Examples of such other layers may include, but are not limited to, a layer C located between layers A and B, and a layer D that is the bottom layer, as described below.

The thickness of the coating layer is not less than 0.26 $\mu$m and not more than 15 $\mu$m. When the thickness of the coating layer is not less than 0.26 $\mu$m, deterioration of the wear resistance of the surface-coated boron nitride sintered body tool due to the thickness of the coating layer being small can be prevented. When the thickness of the coating layer is not more than 15 $\mu$m, the chipping resistance of the coating layer in the initial stage of cutting can be improved. Preferably, the thickness of the coating layer is not less than 1.0 $\mu$m and not more than 4.0 $\mu$m.

The overall thickness of the coating layer and the thickness of each of the layers described below as well as the number of laminated layers are all determined herein by cutting the surface-coated boron nitride sintered body tool, and observing the cross section with an SEM (scanning electron microscope) or a TEM (transmission electron microscope). The composition of each of the layers as described below that constitute the coating layer is measured with an EDX analyzer (energy dispersive X-ray analyzer) equipped with an SEM or a TEM.

While the coating layer may be provided only on the cutting edge portion of the surface-coated boron nitride sintered body tool, it may also be provided over the entire surface of the base material of the surface-coated boron nitride sintered body tool, or may not be provided on a portion of the section different from the cutting edge portion. Alternatively, in the section different from the cutting edge portion, the laminated structure of a portion of the coating layer may be partially different.

<Layer A>

Layer A is composed of $MLa_{z_{a1}}$, where M represents one or more of Al, Si, as well as a group 4 element, a group 5 element, and a group 6 element of the periodic table of the elements; La represents one or more of B, C, N, and O; and za1 is not less than 0.85 and not more than 1.0. This allows layer A to experience smooth wear. In other words, layer A experiences wear without peeling, breaking, chipping, or the like. Therefore, the resistance to crater wear or the resistance to flank-face wear of the surface-coated boron nitride sintered body tool can be improved.

Preferably, layer A is composed of $(Ti_{1-xa}Ma_{xa})(C_{1-za2}N_{za2})$, where Ma represents one or more of Al, Si, as well as a group 4 element, a group 5 element, and a group 6 element of the periodic table of the elements except for Ti; xa is not less than 0 and not more than 0.7; and za2 is not less than 0 and not more than 1. When layer A contains Ti, peeling, breaking, chipping, or the like of layer A during wear can be further prevented. More preferably, the composition xa of Ma is not less than 0 and not more than 0.3. This allows peeling, breaking, chipping, or the like of layer A during wear to be further prevented. It is noted that where layer A is composed of $(Ti_{1-xa(1)-xa(2)}Ma(1)_{xa(1)}Ma(2)_{xa(2)})(C_{1-za2}N_{za2})$, the sum of xa(1) and xa(2) preferably falls within the above-defined range. The same also applies to layers B, C, and D described below.

Preferably, in layer A, the composition of N changes in a step-like or slope-like manner toward a surface-side of layer A from its cBN sintered body-side. For example, when the composition of N is high on the cBN sintered body-side of layer A, defect resistance and peeling resistance can be improved. When the composition of N is low on the surface-side of layer A, peeling, breaking, chipping, or the like of layer A during wear can be further prevented. As used herein, the expression "the composition ofN changes in a step-like manner toward the surface-side of layer A from its cBN sintered body-side" means that the composition ofN decreases or increases discontinuously toward the surface-side of layer A from its cBN sintered body-side, which means, for example, a structure obtained by laminating two or more layers having different compositions ofN. As used herein, the expression "the composition ofN changes in a slope-like manner toward the surface-side of layer A from its cBN sintered body-side" means that the composition ofN decreases or increases continuously toward the surface-side of layer A from its cBN sintered body-side, which means, for example, a structure that is formed while continuously changing the flow rate ratio between the source gas for N and the source gas for C.

Preferably, layer A has, on its surface-side, a region having a higher composition of C than on its cBN sintered body-side. This also allows the defect resistance and peeling resistance to be improved on the cBN sintered body-side of layer A, while allowing peeling, breaking, chipping, or the like of layer A during wear to be further prevented on the surface-side of layer A. As used herein, the "cBN sintered body-side of layer A" means the narrower one of a region not less than 0 $\mu$m and not more than 1/2 times the thickness of layer A distant from a face of layer A situated nearest to the cBN sintered body toward the inside of layer A, and a region not less than 0 $\mu$m and not more than 0.1 $\mu$m distant from the face of layer A situated nearest to the cBN sintered body toward the inside of layer A. As used herein, the "surface-side of layer A" means the opposite side to the cBN sintered body-side of layer A, which is a portion different from the cBN sintered body-side of layer A.

Layer A has a thickness not less than 0.2 $\mu$m and not more than 10 $\mu$m. When layer A has a thickness not less than 0.2 $\mu$m, a surface-coated boron nitride sintered body tool having excellent resistance to crater wear and resistance to flank-face wear can be provided. On the other hand, when layer A has a thickness more than 10 $\mu$m, it may be difficult to further improve the resistance to crater wear or resistance to flank-face wear of the surface-coated boron nitride sintered body tool.

Preferably, layer A is located nearer to a surface-side of the surface-coated boron nitride sintered body tool than layer B. Thus, since layer A experiences smooth wear, the formation of cracks can be prevented. Even if a crack forms, layer B can prevent propagation of the crack toward the base material.

<Layer B>

Layer B is formed by alternately laminating one or more layers of each of two or more thin-film layers having different compositions. In the following, layer B having a structure in which one or more layers of each of a B1 thin-film layer and a B2 thin-film layer are alternately laminated will be described by way of example. Layer B of the invention, however, may include other layers in addition to the B 1 thin-film layer and the B2 thin-film layer, as long as it includes the B1 thin-film layer and the B2 thin-film layer. Layer B has a thickness not less than 0.06 $\mu$m and not more than 5 $\mu$m.

Preferably, the average value of the Si composition in layer B as a whole is not less than 0.003 and not more than 0.1. This allows the peeling resistance of layer B to be increased, which allows oxygen to be prevented from entering into the interface between layer B and layer A or the base material. The average value of the Si composition in layer B as a whole is more preferably not less than 0.005 and not more than 0.07, and even more preferably not less than 0.007 and not more than 0.05. The average value of the Si composition in layer B as a whole is herein determined using the following equation:

$$\text{(average value of Si composition in layer B as a whole)} = [\text{sum total of } \{(\text{Si composition of each layer constituting layer B}) \times (\text{thickness of each layer})\}] / (\text{overall thickness of layer B}).$$

The B1 thin-film layer is formed by alternately laminating one or more layers of each of two or more compound layers having different compositions. In the following, a B1 thin-film layer having a structure in which one or more layers of each of a B1a compound layer and a B1b compound layer are alternately laminated will be described by way of example. The B1 thin-film layer of the invention, however, may include other layers in addition to the B1a compound layer and the B1b compound layer, as long as it includes the B1a compound layer and the B1b compound layer. The B1 thin-film layer has a thickness more than 30 nm and less than 200 nm.

The B1a compound layer is composed of $(Ti_{1-xb1-yb1}Si_{xb1}M1_{yb1})(C_{1-zb1}N_{zb1})$, where M1 represents one or more of Al as well as a group 4 element, a group 5 element, and a group 6 element of the periodic table of the elements except for Ti; xb1 is not less than 0.01 and not more than 0.25; yb1 is not less than 0 and not more than 0.7; and zb1 is not less than 0.4 and not more than 1. The B1a compound layer has a thickness not less than 0.5 nm and less than 30 nm.

The B1b compound layer is composed of $(Al_{1-xb2}M2_{xb2})(C_{1-zb2}N_{zb2})$, where M2 represents one or more of Si as well as a group 4 element, a group 5 element, and a group 6 element of the periodic table of the elements; xb2 is not less than 0.2 and not more than 0.77; and zb2 is not less than 0.4 and not more than 1. M2 preferably represents at least one of Ti and Cr. The composition xb2 of M2 is preferably not less than 0.25 and not more than 0.5, and more preferably not less than 0.25 and not more than 0.4. The B1b compound layer has a thickness not less than 0.5 nm and less than 30 nm.

The B2 thin-film layer is composed of $(Al_{1-xb3}M3_{xb3})(C_{1-zb3}N_{zb3})$, where M3 represents one or more of Si as well as a group 4 element, a group 5 element, and a group 6 element of the periodic table of the elements; xb3 is not less than 0.2 and not more than 0.77; and zb3 is not less than 0.4 and not more than 1. M3 preferably represents at least one of Ti and Cr, and more preferably represents the same element as that of M2. The composition xb3 of M3 is preferably not less than 0.25 and not more than 0.5, more preferably not less than 0.25 and not more than 0.4, and still more preferably the same value as that of the composition xb2 of M2. The B2 thin-film layer has a thickness more than 30 nm and less than 200 nm.

Preferably, t2/t1, which is the ratio of an average thickness t2 of the B2 thin-film layers with respect to an average thickness t1 of the B1 thin-film layers, falls within $0.5 < t2/t1 \leq 10.0$. This allows the resistance to boundary wear and the like of the surface-coated boron nitride sintered body tool (for example, resistance to boundary wear of the surface-coated boron nitride sintered body tool in the case of machining or the like of hardened steel in an environment having low equipment rigidity, low workpiece rigidity, or the like) to be further improved. Average thickness t1 of the B1 thin-film layers is herein determined using the following equation. Average thickness t2 of the B2 thin-film layers is also similarly determined.

$$(\text{average thickness t1 of B1 thin-film layers}) = (\text{sum total of thicknesses of B1 thin-film layers}) / (\text{the number of B1 thin-film layers}).$$

More preferably, t2/t1 falls within $0.7 < t2/t1 \leq 5.0$. This allows the resistance to boundary wear and the like (for example, resistance to boundary wear of the surface-coated boron nitride sintered body tool in the case of machining or the like of hardened steel in an environment having low equipment rigidity, low workpiece rigidity, or the like) of the surface-coated boron nitride sintered body tool to be further improved. Hence, a surface-coated boron nitride sintered body tool having excellent wear resistance against repeated shocks, vibrations, or the like can be provided. More preferably, t2/t1 falls within $1.1 < t2/t1 \leq 4.5$.

Even more preferably, where layer A is located nearer to the surface-side than layer B, t2/t1 falls within $1.1 < t2/t1 \leq 5.0$ on a cBN sintered body-side, decreases toward layer A, and falls within $0.7 < t2/t1 < 2$ on a layer-A side. This allows the formation of cracks to be prevented on the layer A-side of layer B, while preventing the propagation of cracks toward the cBN sintered body on the cBN sintered body-side of layer B. As used herein, the "layer A-side of layer B" means the B1 thin-film layer and the B2 thin-film layer situated nearest to layer A. As used herein, the "cBN sintered body-side of layer B" means the B 1 thin-film layer and the B2 thin-film layer situated nearest to the cBN sintered body.

<Layer C>

Preferably, the coating layer further includes layer C located between layer A and layer B, and layer C is composed of $McLc_{zc}$, where Mc represents one or more of Al, Si, as well as a group 4 element, a group 5 element, and a group 6 element of the periodic table of the elements; Lc represents one or more of B, C, N, and O; and zc is not less than 0 and not more than 0.85. This allows the adhesion between layer A and layer B to be increased. Furthermore, where layer A is located nearer to the surface-side than layer B, the propagation of a crack formed in layer A toward the base material can be stopped in layer C.

More preferably, layer C has a thickness not less than 0.005 $\mu$m and not more than 0.5 $\mu$m. When layer C has a thickness not less than 0.005 $\mu$m, a sufficient effect can be obtained by providing layer C. When layer C has a thickness not more than 0.5 $\mu$m, the thickness of the coating layer can be prevented from becoming excessively great due to layer C being provided. Even more preferably, layer C has a thickness not less than 0.01 $\mu$m and not more than 0.2 $\mu$m.

More preferably, the composition zc of Lc is more than 0 and less than 0.7. When the composition zc of Lc is more than 0, the heat resistance and the chemical wear resistance of layer C can be improved, which allows the propagation of a crack formed in layer A to be effectively prevented in layer C. Even more preferably, the composition zc of Lc is not less than 0.2 and not more than 0.5.

More preferably, layer C includes at least one or more of the elements forming layer A and layer B. When layer C includes at least one or more of the elements forming layer A, the adhesion between layer A and layer C can be increased. When layer C includes at least one or more of the elements forming layer B, the adhesion between layer B and layer C can be increased. More preferably, layer C includes at least one or more of the elements forming a portion situated on a layer C-side of each of layer A and layer B.

<Layer D>

Preferably, the coating layer further includes layer D located between the base material and layer B, and layer D is composed of $MdLd_{zd}$, where Md represents one or more of Al, Si, as well as a group 4 element, a group 5 element, and a group 6 element of the periodic table of the elements; Ld represents one or more of B, C, N, and O; and zd is not less than 0.85 and not more than 1.0. This layer D has excellent adhesion with the cBN sintered body. Thus, when the coating layer further includes layer D, the adhesion between the cBN sintered body and the coating layer can be increased. More preferably, Ld is N.

More preferably, layer D is composed of $(Al_{1-xd}Md2_{xd})Ld_{zd}$, where Md2 represents one or more of Si as well as a group 4 element, a group 5 element, and a group 6 element of the periodic table of the elements; and xd is not less than 0.25 and not more than 0.45. When layer D includes Al, the adhesion between the cBN sintered body and the coating layer can be further increased. Even more preferably, Md2 is at least one or more of Ti, Cr, and V.

More preferably, layer D has a thickness not less than 0.05 $\mu$m and not more than 1 $\mu$m. When layer D has a thickness not less than 0.05 $\mu$m, a sufficient effect can be obtained by providing layer D. When layer D has a thickness not more than 1 $\mu$m, the thickness of the coating layer can be prevented from becoming excessively great due to layer D being provided. Even more preferably, layer D has a thickness not less than 0.1 $\mu$m and not more than 0.5 $\mu$m.

<Method for Manufacturing Surface-Coated Boron Nitride Sintered Body Tool>

A method for manufacturing the surface-coated boron nitride sintered body tool according to the invention includes, for example, the steps of preparing a base material containing the cBN sintered body in at least a cutting edge portion, and forming a coating layer at least on a surface of the cBN sintered body. The step of preparing the base material preferably includes the step of forming the cBN sintered body, and the step of forming the cBN sintered body preferably includes the step of sintering a mixture of cBN particles and a raw-material powder of the binder phase at a high temperature and a high pressure. More preferably, the step of preparing the base material further includes the step of binding the cBN sintered body to the base material body having a predetermined shape.

The step of forming the coating layer preferably includes the step of forming a coating layer using an arc ion plating method (an ion plating method that causes a solid material to evaporate, using vacuum arc discharge), or the step of forming the coating layer using a sputtering method. With the arc ion plating method, the coating layer can be formed using a metal evaporation source containing a metal species for forming the coating layer, and a reactant gas such as $CH_4$, $N_2$, $O_2$, or the like. Known conditions can be employed as the conditions for forming the coating layer. With the sputtering method, the coating layer can be formed using a metal evaporation source containing a metal species for forming the coating layer, a reactant gas such as $CH_4$, $N_2$, $O_2$, or the like, and a sputtering gas such as Ar, Kr, Xe, or the like. Known conditions can be employed as the conditions for forming the coating layer.

[Examples]

While the present invention will be described in more detail hereinafter with reference to Examples, the present invention is not limited thereto.

< Manufacture of Surface-Coated Boron Nitride Sintered Body Tool>

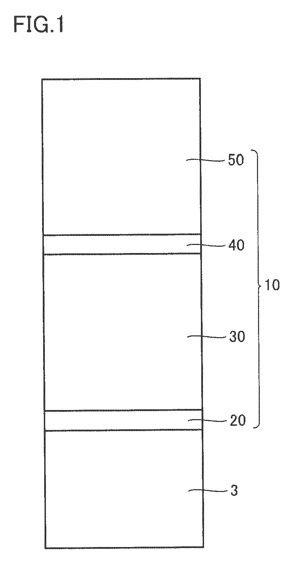

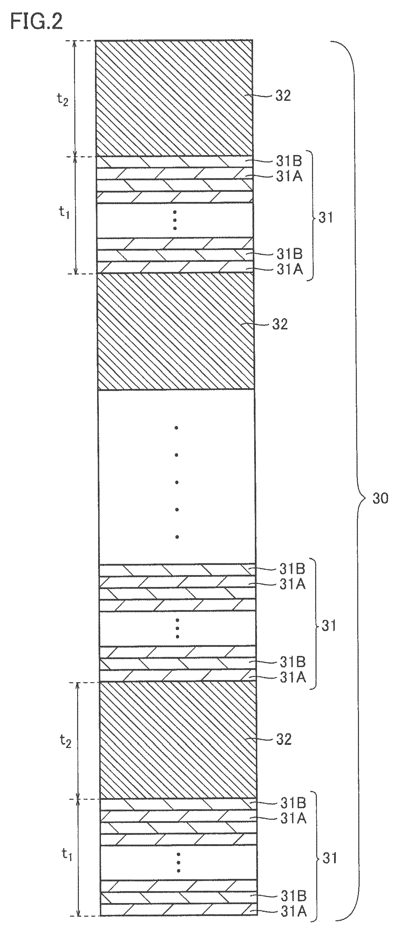

Fig. 1 is a cross-sectional view showing one exemplary structure of a surface-coated boron nitride sintered body tool according to an example of the invention. Fig. 2 is a cross-sectional view showing one exemplary structure of a principal part of the surface-coated boron nitride sintered body tool according to an example of the invention.

<Manufacture of Sample 1>

<Formation of cBN Sintered Body A>

First, a TiN powder having an average particle size of 1 $\mu$m and a Ti powder having an average particle size of 3 $\mu$m were mixed to give an atomic ratio of Ti:N = 1:0.6. The resulting mixture was heat-treated for 30 minutes in vacuum at 1200°C, and then ground. An intermetallic compound powder made of $TiN_{0.6}$ was thus obtained.

Next, the intermetallic compound powder made of $TiN_{0.6}$ and an Al powder having an average particle size of 4 $\mu$m were mixed to give a mass ratio of $TiN_{0.6}$:Al = 90:10. The resulting mixture was heat-treated for 30 minutes in vacuum at 1000°C. The compound obtained by the heat treatment was uniformly ground with a ball mill using ball media made of cemented carbide and having a diameter of 6 mm. A raw-material powder of the binder phase was thus obtained.

Then, the raw-material powder of the binder phase and cBN particles having an average particle size of 1.5 µm were blended such that the cBN content in the cBN sintered body would be 30% by volume, and were uniformly mixed with a ball mill using ball media made of boron nitride and having a diameter of 3 mm. The resulting mixed powder was deposited on a support plate made of cemented carbide, and was loaded into an Mo capsule. The mixed powder was then sintered for 30 minutes using an ultrahigh pressure apparatus at a temperature of 1300°C and a pressure of 5.5 GPa. A cBN sintered body A was thus obtained.

<Formation of Base Material>

A base material body made of a cemented carbide material (equivalent to K10) and having the shape of ISO CNGA12048 was prepared. The above-described cBN sintered body A (shape: a 2-mm-thick triangular prism having isosceles triangles as bases whose vertex angle was 80° and sides sandwiching the vertex angle were each 2 mm) was bonded to an insert (corner portion) of the prepared base material body. A braze material made of Ti-Zr-Cu was used for bonding. The bonded body had its peripheral faces, upper face and lower face ground to form a negative land (having a width of 150 µm and an angle of 25°) on the insert. In this way, a base material 3 having a cutting edge portion made of cBN sintered body A was obtained.

The obtained base material 3 was placed within a film deposition apparatus, the apparatus was evacuated and heated to 500°C, and then base material 3 was etched with Ar ions. The Ar gas was then exhausted from the film deposition apparatus.

<Formation of Coating Layer>

<Formation of Layer D>

A layer D 20 was formed on base material 3 within the above-described film deposition apparatus. Specifically, layer D having a thickness of 0.2 µm was formed by vapor deposition under the following conditions:

    Target: contains 65 atomic % of Al and 35 atomic % of Cr
    Introduced gas: $N_2$
    Film deposition pressure: 4 Pa
    Arc discharge current: 120 A
    Substrate bias voltage: -50 V
    Table rotating speed: 3 rpm.
    <Formation of Layer B>

A layer B 30 was formed on layer D 20 within the above-described film deposition apparatus. Specifically, a B1 thin-film layer 31 having an overall thickness of 50 nm was formed first by vapor deposition under the following conditions. At this time, the arc current for targets B1a and B1b and the rotation speed of the rotation table on which the base material was set were adjusted such that the thickness of a B1a compound layer 31A would be 4 nm, and the thickness of a B1b compound layer 31B would be 6 nm.

    Target B1a: contains 90 atomic % of Ti, 3 atomic % of Si, and 7 atomic % of Cr.
    Target B1b: contains 65 atomic % of Al and 35 atomic % of Cr
    Introduced gas: $N_2$
    Film deposition pressure: 3 Pa
    Substrate bias voltage: -50V.

A B2 thin-film layer 32 having an overall thickness of 120 nm was formed by vapor deposition under the following conditions:

    Target B2: contains 65 atomic % of A1 and 35 atomic % of Cr
    Introduced gas: $N_2$
    Film deposition pressure: 3 Pa
    Arc discharge current: 120 A
    Substrate bias voltage: -75 V
    Table rotating speed: 3 rpm.

Then, six B 1 thin-film layers 31 and six B2 thin-film layers 32 were alternately laminated on one another. In this way, layer B 30 having an overall thickness of 1.02 µm was formed.

<Formation of Layer C>

A layer C 40 was formed on layer B 30 within the above-described film deposition apparatus. Specifically, layer C 40 having a thickness of 0.2 $\mu$m was formed by vapor deposition under the following conditions:

Target: Ti
Introduced gas: Ar
Film deposition pressure: 2 Pa
Arc discharge current: 150 A
Substrate bias voltage: -70 V
Table rotating speed: 3 rpm.

<Formation of Layer A>

A layer A 50 was formed on layer C 40 within the above-described film deposition apparatus. Specifically, layer A having a thickness of 0.1 $\mu$m was formed by vapor deposition under the following conditions:

Target: contains 50 atomic % of Ti and 50 atomic % of Al
Introduced gas: $N_2$
Film deposition pressure: 4 Pa
Arc discharge current: 120 A
Substrate bias voltage: -600 V
Table rotating speed: 3 rpm.

As described above, a coating layer 10 sequentially including layer D 20, layer B 30, layer C 40, and layer A 50 on base material 3 was formed, and thus, sample 1 was manufactured.

<Manufacture of Samples 2 to 7>

Each of samples 2 to 7 was manufactured following the method for manufacturing sample 1 described above, except that the thickness of layer A was changed to the value shown in Table 1.

<Manufacture of Sample 8>

A cBN sintered body D was obtained following the method for forming cBN sintered body A described above, except that the cBN particles and the raw-material powder of the binder phase were blended such that the cBN content in the cBN sintered body would become the value shown in Table 3. A base material of sample 8 was formed following the method for manufacturing the base material of sample 1 described above, using the obtained cBN sintered body D.
Next, layers D and B were sequentially formed following the method for manufacturing sample 1 described above. Layer A was then formed without forming layer C. Specifically, the film deposition pressure was set to 2 Pa with the introduction of $N_2$ only during the period of time from the beginning of the formation of layer A until the thickness of layer A reached 1 $\mu$m. $N_2$ was then gradually reduced while gradually increasing $CH_4$, further forming layer A in an additional thickness of 1 $\mu$m. At this time, $N_2$ was gradually reduced while gradually increasing $CH_4$ until the composition became $TiC_{0.5}N_{0.5}$. Then, layer A was further formed in an additional thickness of 0.5 $\mu$m without changing the amount of supply of each of $CH_4$ and $N_2$. Sample 8 was thus manufactured.
It is noted that during the manufacture of sample 8, the targets were prepared, and the types of the introduced gases and the amounts of supply thereof were adjusted, such that the layers of the compositions shown in Tables 1 and 2 were obtained. As the introduced gases, Ar, $N_2$, $CH_4$, and the like were used as appropriate. The film deposition pressure was adjusted as appropriate within the range of 0.1 Pa to 7 Pa, the arc discharge current was adjusted as appropriate within the range of 60 A to 200 A, and the substrate bias voltage was adjusted as appropriate within the range of -25 V to -700 V. The same also applies to samples 9 to 56 described below.

(Manufacture of Samples 9 to 13)

Each of samples 9 to 13 was manufactured following the method for manufacturing sample 8 described above, except that layer C made of $TiN_{0.5}$ was formed.

EP 2 979 788 A1

<Manufacture of Samples 14 to 19>

A cBN sintered body C was obtained following the method for forming cBN sintered body A described above, except that the cBN particles and the raw-material powder of the binder phase were blended such that the cBN content in the cBN sintered body would become the value shown in Table 3. A base material of each of samples 14 to 19 was formed following the method for manufacturing the base material of sample 1 described above, using the obtained cBN sintered body C.

Next, layers D and B were sequentially formed following the method for manufacturing sample 1 described above. Layer A was then formed following the method for manufacturing sample 8 described above, without forming layer C. Samples 14 to 19 were thus manufactured.

<Manufacture of Samples 20 to 25>

A cBN sintered body B was obtained following the method for forming cBN sintered body A described above, except that the cBN particles and the raw-material powder of the binder phase were blended such that the cBN content in the cBN sintered body would become the value shown in Table 3. A base material of each of samples 20 to 25 was formed following the method for manufacturing the base material of sample 1 described above, using the obtained cBN sintered body B.

Next, layers D, B, C, and A were sequentially formed following the method for manufacturing sample 1 described above. Samples 20 to 25 were thus manufactured.

<Manufacture of Samples 26 to 30>

A cBN sintered body E was obtained following the method for forming cBN sintered body A described above, except that the cBN particles and the raw-material powder of the binder phase were blended such that the cBN content in the cBN sintered body would become the value shown in Table 3. A base material of sample 26 was formed following the method for manufacturing the base material of sample 1 described above, using the obtained cBN sintered body E.

Next, layers D, B, and A were sequentially formed following the method for manufacturing sample 1 described above. Samples 26 to 30 were thus manufactured.

<Manufacture of Samples 31 to 35>

A cBN sintered body F was obtained following the method for forming cBN sintered body D described above, except that cBN particles having an average particle size of 0.5 $\mu$m and the raw-material powder of the binder phase were blended. A base material of each of samples 31 to 35 was formed following the method for manufacturing the base material of sample 1 described above, using the obtained cBN sintered body F.

Next, layers D, B, and A were sequentially formed following the method for manufacturing sample 1 described above. Samples 31 to 35 were thus manufactured.

<Manufacture of Samples 36 to 40>

A cBN sintered body G was obtained following the method for forming cBN sintered body D described above, except that cBN particles having an average particle size of 3 $\mu$m and the raw-material powder of the binder phase were blended. A base material of each of samples 36 to 40 was formed following the method for manufacturing the base material of sample 1 described above, using the obtained cBN sintered body G.

Next, layers D, B, C, and A were sequentially formed following the method for manufacturing samples 1 and 8 described above. Samples 36 to 40 were thus manufactured.

<Manufacture of Samples 41 to 45>

First, a TiCN powder having an average particle size of 1 $\mu$m and a Ti powder having an average particle size of 3 $\mu$m were mixed to give an atomic ratio of Ti:C:N=1:0.3:0.3. The resulting mixture was heat-treated for 30 minutes in vacuum at 1200°C, and then ground. An intermetallic compound powder made of $TiC_{0.3}N_{0.3}$ was thus obtained.

Next, the intermetallic compound powder made of $TiC_{0.3}N_{0.3}$ and an Al powder having an average particle size of 4 $\mu$m were mixed to give a mass ratio of $TiC_{0.3}N_{0.3}$:Al = 90:10. The resulting mixture was heat-treated for 30 minutes in vacuum at 1000°C. The compound obtained by the heat treatment was uniformly ground with a ball mill using ball media made of cemented carbide and having a diameter of 6 mm. A raw-material powder of the binder phase was thus obtained. Thereafter, a cBN sintered body H was obtained following the method for manufacturing cBN sintered body D described above. A base material of each of samples 41 to 45 was formed following the method for manufacturing the base material of sample 1 described above, using the obtained cBN sintered body H.

Next, layers D, B, C, and A were sequentially formed following the method for manufacturing samples 1 and 8 described above. Samples 41 to 45 were thus manufactured.

<Manufacture of Samples 46 to 53>

A base material of each of samples 46 to 53 was formed following the method for manufacturing the base material of sample 1 described above, using the cBN sintered body shown in Table 1. Next, layers D, B, and A were sequentially formed following the method for manufacturing samples 1 and 8 described above. Samples 46 to 53 were thus manufactured. <Manufacture of Sample 54>

First, a TiC powder having an average particle size of 1 $\mu$m and a Ti powder having an average particle size of 3 $\mu$m were mixed to give an atomic ratio of Ti:C = 1:0.6. The resulting mixture was heat-treated for 30 minutes in vacuum at 1200°C, and then ground. An intermetallic compound powder made of $TiC_{0.6}$ was thus obtained.

Next, the intermetallic compound powder made of $TiC_{0.6}$ and an Al powder having an average particle size of 4 $\mu$m were mixed to give a mass ratio of $TiC_{0.6}$:Al = 90:10. The resulting mixture was heat-treated for 30 minutes in vacuum at 1000°C. The compound obtained by the heat treatment was uniformly ground with a ball mill using ball media made of cemented carbide and having a diameter of 6 mm. A raw-material powder of the binder phase was thus obtained. Thereafter, a cBN sintered body I was obtained following the method for manufacturing cBN sintered body D described above. A base material of sample 54 was formed following the method for manufacturing the base material of sample 1 described above, using the obtained cBN sintered body I.

Next, layers D, B, and A were sequentially formed following the method for manufacturing samples 46 to 53 described above. Sample 54 was thus manufactured.

<Manufacture of Sample 55>

Sample 55 was manufactured following the method for manufacturing sample 1 described above, except that layers B, C, and D were not formed.

<Manufacture of Sample 56>

Sample 56 was manufactured following the method for manufacturing sample 1 described above, except that layers A and C were not formed.

[Table 1]

| | | cBN Sintered Body | Coating Layer | | | | | | Thickness of Coating Layer |
| | | | Layer A | | Layer C | | Layer D | | |
| | | | Composition | Thickness ($\mu$m) | Composition | Thickness ($\mu$m) | Composition | Thickness ($\mu$m) | $\mu$m |
|---|---|---|---|---|---|---|---|---|---|
| Comp. Ex. 1 | Sample 1 | A | $Ti_{0.5}Al_{0.5}N$ | 0.1 | Ti | 0.2 | $Al_{0.65}Cr_{0.35}N$ | 0.2 | 1.52 |
| Ex. 1 | 2 | | | 0.5 | | | | | 1.92 |
| Ex. 2 | 3 | | | 1.5 | | | | | 2.92 |
| Ex. 3 | 4 | | | 2.0 | | | | | 3.42 |
| Ex. 4 | 5 | | | 4.0 | | | | | 5.42 |
| Ex. 5 | 6 | | | 7.0 | | | | | 8.42 |
| Comp. Ex. 2 | 7 | | | 15,0 | | | | | 16.42 |
| Ex. 6 | 8 | D | $TiCN^{*01}$ | 2.5 | $TiN_{0.5}$ | 0 | $Al_{0.7}Cr_{0.3}N$ | 0.5 | 4.50 |
| Ex. 7 | 9 | | | | | 0.007 | | | 4.51 |
| Ex. 8 | 10 | | | | | 0.05 | | | 4.55 |
| Ex. 9 | 11 | | | | | 0.15 | | | 4.65 |
| Ex. 10 | 12 | | | | | 0.25 | | | 4.75 |
| Ex. 11 | 13 | | | | | 1 | | | 5.50 |
| Comp. Ex. 3 | 14 | c | $TiN^{*02}$ | 1.2 | None | 0 | $Al_{0.6}Cr_{0.4}N$ | 0.7 | 2.40 |
| Ex. 12 | 15 | | | | | | | | |
| Ex. 13 | 16 | | | | | | | | |
| Ex. 14 | 17 | | | | | | | | |
| Ex. 15 | 18 | | | | | | | | |
| Comp. Ex. 4 | 19 | | | | | | | | |

EP 2 979 788 A1

13

(continued)

| | | cBN Sintered Body | Coating Layer | | | | | | Thickness of Coating Layer |
|---|---|---|---|---|---|---|---|---|---|
| | | | Layer A | | Layer C | | Layer D | | |
| | | | Composition | Thickness ($\mu$m) | Composition | Thickness ($\mu$m) | Composition | Thickness ($\mu$m) | $\mu$m |
| Comp. Ex. 5 | 20 | B | $Ti_{0.9}Cr_{0.1}C_{0.3}N_{07}$ | 3.0 | $Ti_{0.9}Cr_{0.1}C_{0.3}N_{0.3}$ | 0.05 | $Al_{0.5}Ti_{0.5}N$ | 0.1 | 4.05 |
| Ex. 16 | 21 | | | | | | | | |
| Ex. 17 | 22 | | | | | | | | |
| Ex. 18 | 23 | | | | | | | | |
| Ex. 19 | 24 | | | | | | | | |
| Comp. Ex. 6 | 25 | | | | | | | | |
| Comp. Ex. 7 | 26 | E | $Ti_{0.85}Nb_{0.15}C_{0.3}N_{0.7}$ | 0.5 | None | 0 | $Al_{0.3}Ti_{0.7}N$ | 0.3 | 2.30 |
| Ex. 20 | 27 | | | | | | | | |
| Ex. 21 | 28 | | | | | | | | |
| Ex. 22 | 29 | | | | | | | | |
| Comp. Ex. 8 | 30 | | | | | | | | |
| Comp. Ex. 9 | 31 | F | $Ti_{0.5}Zr_{0.5}C_{0.2}N_{0.8}$ | 0.7 | None | 0 | $Al_{0.5}Cr_{0.4}Si_{0.1}N$ | 1 | 3.30 |
| Ex. 23 | 32 | | | | | | | | 2.76 |
| Ex. 24 | 33 | | | | | | | | 2.68 |
| Ex. 25 | 34 | | | | | | | | 2.80 |
| Comp. Ex. 10 | 35 | | | | | | | | 2.60 |

EP 2 979 788 A1

| | | cBN Sintered Body | Coating Layer | | | | | | |
| | | | Layer A | | Layer C | | Layer D | | Thickness of Coating Layer |
| | | | Composition | Thickness ($\mu$m) | Composition | Thickness ($\mu$m) | Composition | Thickness ($\mu$m) | $\mu$m |
|---|---|---|---|---|---|---|---|---|---|
| Comp. Ex. 11 | 36 | G | $TiC^{*03}$ | 1.5 | $TiN_{0.4}$ | 0.1 | $Al_{0.65}Cr_{0.2}Ti_{0.15}N$ | 0.1 | 2.50 |
| Ex. 26 | 37 | | | | | | | | 2.48 |
| Ex. 27 | 38 | | | | | | | | 2.50 |
| Ex. 28 | 39 | | | | | | | | 2.45 |
| Comp. Ex. 12 | 40 | | | | | | | | 2.46 |
| Comp. Ex. 13 | 41 | H | $Ti_{0.9}W_{0.1}CN^{*04}$ | 3.0 | $Ti_{0.3}Cr_{0.2}W_{0.1}$ | 0.05 | $Al_{0.7}Cr_{0.1}Ti_{0.2}N$ | 0.2 | 3.28 |
| Ex. 29 | 42 | | | | | | | | 3.40 |
| Ex. 30 | 43 | | | | | | | | 4.75 |
| Ex. 31 | 44 | | | | | | | | 6.25 |
| Comp. Ex. 14 | 45 | | | | | | | | 9.25 |
| Ex. 32 | 46 | A | $TiCN^{*05}$ | 2 | None | 0 | $Al_{0.65}Cr_{0.35}N$ | 0.2 | 3.95 |
| Ex. 33 | 47 | B | | | | | | | |
| Ex. 34 | 48 | C | | | | | | | |
| Ex. 35 | 49 | D | | | | | | | |
| Ex. 36 | 50 | E | | | | | | | |
| Ex. 37 | 51 | F | | | | | | | |
| Ex. 38 | 52 | G | | | | | | | |
| Ex. 39 | 53 | H | | | | | | | |
| Ex. 40 | 54 | I | | | | | | | |

(continued)

| | | cBN Sintered Body | Coating Layer | | | | | | |
|---|---|---|---|---|---|---|---|---|---|
| | | | Layer A | | Layer C | | Layer D | | Thickness of Coating Layer |
| | | | Composition | Thickness ($\mu$m) | Composition | Thickness ($\mu$m) | Composition | Thickness ($\mu$m) | $\mu$m |
| Comp. Ex. 15 | 55 | D | $Ti_{0.5}Al_{0.5}N$ | 3.0 | None | | None | | 3.00 |
| Comp. Ex. 16 | 56 | D | None | | None | | $Al_{0.7}Cr_{0.3}N$ | 0.5 | 2.98 |

[Table 2] (1/2)

| | | Coating Layer (Layer B) | | | | | | | | | | | | | |
| | | B1 Thin-Film Layer | | | | | | B2 Thin-Film Layer | | Number of Layer[22] | Thick-ness ($\mu$m) | t2/t1 | | | Average Value of Si Composition |
| | | B1a Compound Layer | | B2b Compound Layer | | Number of Lay-ers[21] | Thick-ness (nm) | | | | | Sin-tered Body-Side[31] | Layer A-Side [32] | Aver-age | |
| | | Composition | Thick-ness (nm) | Composition | Thick-ness (nm) | | | Composition | Thick-ness (nm) | | | | | | |
| Comp. Ex. 1 | Sam-ple 1 | Ti$_{0.9}$Si$_{0.03}$Cr$_{0.07}$N | 4 | Al$_{0.65}$Cr$_{0.35}$N | 6 | 10 | 50 | Al$_{0.65}$Cr$_{0.35}$N | 120 | 12 | 1.02 | - | - | 2.4 | 0.0035 |
| Ex. 1 | 2 | | | | | | | | | | | | | | |
| Ex. 2 | 3 | | | | | | | | | | | | | | |
| Ex. 3 | 4 | | | | | | | | | | | | | | |
| Ex. 4 | 5 | | | | | | | | | | | | | | |
| Ex. 5 | 6 | | | | | | | | | | | | | | |
| Comp. Ex. 2 | 7 | | | | | | | | | | | | | | |
| Ex. 6 | 8 | Ti$_{0.93}$Si$_{0.07}$N | 7 | Al$_{0.7}$Cr$_{0.3}$N | 10 | 4 | 34 | Al$_{0.7}$Cr$_{0.3}$N | 90 | 24 | 1.5 | - | - | 2.6 | 0.0079 |
| Ex. 7 | 9 | | | | | | | | | | | | | | |
| Ex. 8 | 10 | | | | | | | | | | | | | | |
| Ex. 9 | 11 | | | | | | | | | | | | | | |
| Ex. 10 | 12 | | | | | | | | | | | | | | |
| Ex. 11 | 13 | | | | | | | | | | | | | | |

| | | Coating Layer (Layer B) | | | | | | | | | | | | | |
| --- | --- | --- | --- | --- | --- | --- | --- | --- | --- | --- | --- | --- | --- | --- | --- |
| | | B1 Thin-Film Layer | | | | | | B2 Thin-Film Layer | | Number of Layer 22 | Thickness (μm) | t2/t1 | | | Average Value of Si Composition |
| | | B1a Compound Layer | | B2b Compound Layer | | Number of Layers*21 | Thickness (nm) | | | | | Sintered Body-Side*31 | Layer A-Side*32 | Average | |
| | | Composition | Thickness (nm) | Composition | Thickness (nm) | | | Composition | Thickness (nm) | | | | | | |
| Comp. Ex. 3 | 14 | $Ti_{0.92}Nb_{0.08}N$ | 10 | $Al_{0.6}Cr_{0.4}N$ | 20 | 6 | 90 | $Al_{0.6}Cr_{0.4}N$ | 160 | 4 | 0.5 | - | - | 1.8 | 0.0000 |
| Ex. 12 | 15 | $Ti_{0.915}Si_{0.005}Nb_{0.06}N$ | | | | | | | | | | | | | 0.0006 |
| Ex. 13 | 16 | $Ti_{0.87}Si_{0.05}Nb_{0.08}N$ | | | | | | | | | | | | | 0.0060 |
| Ex. 14 | 17 | $Ti_{0.82}Si_{0.1}Nb_{0.08}N$ | | | | | | | | | | | | | 0.0120 |
| Ex. 15 | 18 | $Ti_{0.74}Si_{0.1}a Nb_{0.08}N$ | | | | | | | | | | | | | 0.0216 |
| Comp. Ex. 4 | 19 | $Ti_{0.42}Si_{0.5}Nb_{0.08}N$ | | | | | | | | | | | | | 0.0600 |
| Comp. Ex. 5 | 20 | $Ti_{0.85}Si_{0.15}N$ | 0.4 | $Al_{0.5}Ti_{0.5}N$ | 0.4 | 400 | 160 | $Al_{0.5}Ti_{0.5}N$ | 180 | 5 | 0.9 | - | - | 1.1 | 0.0353 |
| Ex. 16 | 21 | | 1.5 | | 2.5 | 80 | | | | | | | | | 0.0265 |
| Ex. 17 | 22 | | 3 | | 7 | 32 | | | | | | | | | 0.0212 |
| Ex. 18 | 23 | | 6 | | 12 | 18 | | | | | | | | | 0.0235 |
| Ex. 19 | 24 | | 20 | | 15 | 9 | | | | | | | | | 0.0403 |
| Comp. Ex. 6 | 25 | | 45 | | 35 | 4 | | | | | | | | | 0.0397 |

EP 2 979 788 A1

18

EP 2 979 788 A1

(continued)

| | | Coating Layer (Layer B) | | | | | | | | | | | | | |
|---|---|---|---|---|---|---|---|---|---|---|---|---|---|---|---|
| | | B1 Thin-Film Layer | | | | | | B2 Thin-Film Layer | | Number of Layer 22 | Thick-ness (μm) | t2/t1 | | | Average Value of Si Composition |
| | | B1a Compound Layer | | B2b Compound Layer | | Number of Lay-ers*21 | Thick-ness (nm) | | | | | Sin-tered Body-Side*31 | Layer A-Side *32 | Aver-age | |
| | | Composition | Thick-ness (nm) | Composition | Thick-ness (nm) | | | Composition | Thick-ness (nm) | | | | | | |
| Comp. Ex. 7 | 26 | $Ti_{0.8}Si_{0.2}N$ | 3 | TiN | 7 | 8 | 40 | TiN | 60 | 30 | 1.5 | - | - | 1.5 | 0.024 |
| Ex. 20 | 27 | | | $Al_{0.25}Ti_{0.75}N$ | | | | $Al_{0.25}Ti_{0.75}N$ | | | | | | | |
| Ex. 21 | 28 | | | $Al_{0.5}Ti_{0.5}N$ | | | | $Al_{0.5}Ti_{0.5}N$ | | | | | | | |
| Ex. 22 | 29 | | | $Al_{0.69}Ti_{0.3}N$ | | | | $Al_{0.69}Ti_{0.31}N$ | | | | | | | |
| Comp. Ex. 8 | 30 | | | $Al_{0.9}Ti_{0.1}N$ | | | | $Al_{0.9}Ti_{0.1}N$ | | | | | | | |
| Comp. Ex. 9 | Sample 31 | $Ti_{0.68}Si_{0.22}W_{0.1}C_{0.1}N_{0.9}$ | 2 | $Alo_{5}Cr_{0.5}Si_{0.1}C_{0.09}N_{0.9}$ | 3 | 8 | 20 | $Al_{0.5}Cr_{0.4}Si_{0.1}N$ | 180 | 16 | 1.6 | - | - | 9 | 0.1048 |
| Ex. 23 | 32 | | | | | 16 | 40 | | | 16 | 1.76 | | | 4.5 | 0.1087 |
| Ex. 24 | 33 | | | | | 40 | 100 | | | 12 | 1.68 | | | 1.8 | 0.1171 |
| Ex. 25 | 34 | | | | | 72 | 180 | | | 10 | 1.8 | | | 1 | 0.1240 |
| Comp. Ex. 10 | 35 | | | | | 88 | 220 | | | 8 | 1.6 | | | 0.8 | 0.1264 |

(continued)

| | | Coating Layer (Layer B) | | | | | | | | | | | | |
|---|---|---|---|---|---|---|---|---|---|---|---|---|---|---|
| | | B1 Thin-Film Layer | | | | | | B2 Thin-Film Layer | | Number of Layer [22] | Thick-ness ($\mu$m) | t2/t1 | | Average Value of Si Composition |
| | | B1a Compound Layer | | B2b Compound Layer | | Number of Lay-ers[21] | Thick-ness (nm) | | | | | Sin-tered Body-Side[31] | Layer A-Side [32] | |
| | | Composition | Thick-ness (nm) | Composition | Thick-ness (nm) | | | Composition | Thick-ness (nm) | | | | Aver-age | |
| Comp. Ex. 11 | 36 | Ti$_{0.85}$Si$_{0.15}$N | 3 | Al$_{0.65}$Cr$_{0.2}$Ti$_{0.15}$N | 5 | 20 | 80 | Al$_{0.65}$Cr$_{0.2}$Ti$_{0.15}$N | 20 | 16 | 0.8 | - | - | 0.25 | 0.0450 |
| Ex. 26 | 37 | | | | | | | | 50 | 12 | 0.78 | | | 0.6 | 0.0346 |
| Ex. 27 | 38 | | | | | | | | 120 | 8 | 0.8 | | | 1.5 | 0.0225 |
| Ex. 28 | 39 | | | | | | | | 170 | 6 | 0.75 | | | 2.1 | 0.0180 |
| Comp. Ex. 12 | 40 | | | | | | | | 300 | 4 | 0.76 | | | 3.8 | 0.0118 |
| Comp. Ex. 13 | 41 | Ti$_{0.88}$Si$_{0.07}$Ta$_{0.05}$C$_{0.05}$N$_{0.95}$ | 4 | Al$_{0.7}$Cr$_{0.1}$Ti$_{0.2}$C$_{0.05}$N$_{0.95}$ | 6 | 4 | 20 | Al$_{0.7}$Cr$_{0.1}$Ti$_{0.2}$C$_{0.05}$N$_{0.95}$ | 30 | 2 | 0.05 | - | - | 1.5 | 0.0112 |
| Ex. 29 | 42 | | | | | 8 | 40 | | 40 | 4 | 0.16 | | | 1 | 0.014 |
| Ex. 30 | 43 | | | | | | | | | 40 | 1.6 | | | | |
| Ex. 31 | 44 | | | | | | | | | 100 | 4.0 | | | | |
| Comp. Ex. 14 | 45 | | | | | | | | | 200 | 8.0 | | | | |

EP 2 979 788 A1

(continued)

| | | Coating Layer (Layer B) | | | | | | | | | | | | | |
| | | B1 Thin-Film Layer | | | | | | B2 Thin-Film Layer | | Number of Layer 22 | Thick-ness ($\mu$m) | t2/t1 | | | Average Value of Si Composition |
| | | B1a Compound Layer | | B2b Compound Layer | | Number of Lay-ers*21 | Thick-ness (nm) | | | | | Sin-tered Body-Side*31 | Layer A-Side *32 | Aver-age | |
| | | Composition | Thick-ness (nm) | Composition | Thick-ness (nm) | | | Composition | Thick-ness (nm) | | | | | | |
| Ex. 32 | 46 | $Ti_{0.9}Si_{0.1}N$ | 5 | $Al_{0.65}Cr_{0.35}N$ | 6 | 10 | 55 | $Al_{0.65}Cr_{0.35}N$ | 120 | 10 | 1.8 | 4 | 0.8 | 2.2 | 0.0143 |
| Ex. 33 | 47 | | | | | | | | | | | | | | |
| Ex. 34 | 48 | | | | | | | | | | | | | | |
| Ex. 35 | 49 | | | | | | | | | | | | | | |
| Ex. 36 | 50 | | | | | | | | | | | | | | |
| Ex. 37 | 51 | | | | | | | | | | | | | | |
| Ex. 38 | 52 | | | | | | | | | | | | | | |
| Ex. 39 | 53 | | | | | | | | | | | | | | |
| Ex. 40 | 54 | | | | | | | | | | | | | | |
| Comp. Ex. 15 | 55 | None | | | | | | | | | | | | | |
| Comp. Ex. 16 | 56 | $Ti_{0.93}Si_{0.07}N$ | 7 | $Al_{0.7}Cr_{0.3}N$ | 10 | 4 | 34 | $Al_{0.7}Cr_{0.3}N$ | 90 | 40 | 2.48 | - | | 2.6 | 0.0079 |

[Table 3]

| cBN Sintered Body | cBN Content (% by Volume) | Average Particle Size of cBN (μm) | Raw Material Powder of Binder Phase | Compounds Detected with X-Rays |
|---|---|---|---|---|
| A | 30 | 1.5 | $TiN_{0.6}$, Al | cBN, TiN, $TiB_2(AlB_2)$ |
| B | 80 | 1.5 | $TiN_{0.6}$, Al | cBN, TiN, $TiB_2(AlB_2)$ |
| C | 50 | 1.5 | $TiN_{0.6}$, Al | cBN, TiN, $TiB_2(AlB_2)$ |
| D | 58 | 1.5 | $TiN_{0.6}$ Al | cBN, TiN, $TiB_2(AlB_2)$ |
| E | 65 | 1.5 | $TiN_{0.6}$, Al | cBN, TiN, $TiB_2(AlB_2)$ |
| F | 58 | 0.5 | $TiN_{0.6}$, Al | cBN, TiN, $TiB_2(AlB_2)$ |
| G | 58 | 3 | $TiN_{0.6}$, Al | cBN, TiN, $TiB_2(AlB_2)$ |
| H | 58 | 1.5 | $TiC_{0.3}N_{0.3}$, Al | cBN, TiCN, $TiB_2(AlB_2)$ |
| I | 58 | 1.5 | $TiC_{0.6}$, Al | cBN, TiC, $TiB_2(AlB_2)$ |

TiCN[*01] to TiCN[*05] in Table 1 are as shown in Table 4. In Table 2, Number of Layers[*21] denotes the sum total of the number of B1a compound layers and the number of Bib compound layers, and Number of Layers[*22] denotes the sum total of the number of B1 thin-film layers and the number of B2 thin-film layers. Moreover, in Table 2, Sintered Body-Side[*31] denotes t2/t1 on the cBN sintered body-side of layer B, Layer A-Side[*32] denotes t2/t1 on the layer A-side of layer B, and Average[*33] denotes t2/t1 for layer B as a whole. With regard to samples for which the "Sintered Body-Side[*31]" column and the "Layer A-Side[*32]" column are blank, t2/t2 has the same value between the cBN sintered body-side and the layer A-side (the value shown in "Average[*33]").

[Table 4]

|  | Distance from Base Material-Side (μm) | N Composition Ratio | C Composition Ratio |
|---|---|---|---|
| TiCN*01 | 0-1 | 1 | 0 |
|  | 1-2 | 1→0.5 | 0→0.5 |
|  | 2-2.5 | 0.5 | 0.5 |
| TiCN[*02] | 0-1.2 | 1→0.5 | 0→0.5 |
| TiCN*03 | 0-0.2 | 1 | 0 |
|  | 0.2-0.5 | 1→0.4 | 0→0.6 |
|  | 0.5-1.0 | 0.4→0.7 | 0.6→0.3 |
|  | 1.0-1.5 | 0.5 | 0.5 |
| $Ti_{0.9}W_{0.1}CN$[*04] | 0-3.0 | 1→0.3 | 0→0.7 |
| TiCN[*05] | 0-2 | 1→0.5 | 0→0.5 |
| In Table 4, the recitation "1→0.5", for example, means that the composition ratio gradually changes from 1 to 0.5. | | | |

<Measurement of Flank-Face Wear Amount VB and Surface Roughness Rz>

Using the manufactured samples 1 to 56, cutting was performed (cutting distance: 2 km) under the following cutting conditions. Then, a flank-face wear amount VB was measured with an optical microscope, and surface roughness Rz of the surface of a workpiece was measured in accordance with the JIS standard. Measured results of flank-face wear amounts VB are shown in the "VB (mm)" column of Table 5, and measured results of surface roughness Rz of surfaces of workpieces are shown in the "Rz (μm)" column of Table 5. A smaller VB indicates higher resistance to flank-face wear of the surface-coated boron nitride sintered body tool. A smaller Rz indicates higher tool performance in high-precision machining using the surface roughness of a workpiece as a criterion of determining the life of the surface-coated boron nitride sintered body tool.

(Cutting Conditions)

Workpiece: high hardness steel (SCM415H/HRC60) (outer diameter $\phi$ 30 mm, longitudinal cutting length: 10 mm)
Tool: CNGA120408 wiper
Cutting speed: 150 mm/min
Feed rate: f = 0.2 mm/rev
Cutting depth: ap = 0.2 mm
Cutting oil: an emulsion (manufactured by Japan Fluid System under the trade name "System Cut 96") 20-fold diluted (wet state).

<Measurement of Tool Life>

Using the manufactured samples 1 to 56, cutting was performed under the above-described cutting conditions. Surface roughness Rz of the workpiece was then measured with a surface roughness meter, and a cutting distance at the moment when surface roughness Rz of the workpiece became 3.2 $\mu$m was measured. The results are shown in the "Cutting Distance (km)" column of Table 5. A longer cutting distance indicates higher resistance to flank-face wear, resistance to crater wear, and resistance to boundary wear of the surface-coated boron nitride sintered body tool.

<Results and Consideration>

The results are shown in Table 5.

[Table 5]

|  |  | Cutting Evaluation Results | | |
|---|---|---|---|---|
|  |  | VB (mm) | Rz ($\mu$m) | Cutting Distance (km) |
| Comp. Ex. 1 | Sample 1 | 0.06 | 2.2 | 3.9 |
| Ex. 1 | Sample 2 | 0.055 | 0.8 | 8.7 |
| Ex. 2 | Sample 3 | 0.048 | 0.75 | 9.1 |
| Ex. 3 | Sample 4 | 0.042 | 0.73 | 9.2 |
| Ex. 4 | Sample 5 | 0.04 | 0.8 | 8.6 |
| Ex. 5 | Sample 6 | 0.042 | 0.91 | 8.3 |
| Comp. Ex. 2 | Sample 7 | 0.052 | 2.8 | 3.6 |
| Ex. 6 | Sample 8 | 0.049 | 0.81 | 8.7 |
| Ex. 7 | Sample 9 | 0.048 | 0.78 | 8.7 |
| Ex. 8 | Sample 10 | 0.047 | 0.75 | 9 |
| Ex. 9 | Sample 11 | 0.048 | 0.77 | 8.8 |
| Ex. 10 | Sample 12 | 0.05 | 0.8 | 8.7 |
| Ex. 11 | Sample 13 | 0.055 | 0.9 | 8.6 |
| Comp. Ex. 3 | Sample 14 | 0.062 | 2.4 | 3.8 |
| Ex. 12 | Sample 15 | 0.065 | 0.95 | 8.9 |
| Ex. 13 | Sample 16 | 0.062 | 0.78 | 8.8 |
| Ex. 14 | Sample 17 | 0.051 | 0.7 | 9.3 |
| Ex. 15 | Sample 18 | 0.045 | 0.72 | 9 |
| Comp. Ex. 4 | Sample 19 | 0.063 | 2.5 | 3.6 |
| Comp. Ex. 5 | Sample 20 | 0.05 | 2.3 | 3.9 |

(continued)

| | | Cutting Evaluation Results | | |
|---|---|---|---|---|
| | | VB (mm) | Rz (μm) | Cutting Distance (km) |
| Ex. 16 | Sample 21 | 0.046 | 0.99 | 8.3 |
| Ex. 17 | Sample 22 | 0.045 | 0.9 | 8.5 |
| Ex. 18 | Sample 23 | 0.047 | 0.95 | 8.3 |
| Ex. 19 | Sample 24 | 0.049 | 1.05 | 8.2 |
| Comp. Ex. 6 | Sample 25 | 0.051 | 2.8 | 3.2 |
| Comp. Ex. 7 | Sample 26 | 0.59 | 3.5 | 3.1 |
| Ex. 20 | Sample 27 | 0.57 | 1.05 | 8.3 |
| Ex. 21 | Sample 28 | 0.57 | 1 | 8.4 |
| Ex. 22 | Sample 29 | 0.055 | 1.07 | 8.2 |
| Comp. Ex. 8 | Sample 30 | 0.56 | 3 | 3.2 |
| Comp. Ex. 9 | Sample 31 | 0.57 | 2.3 | 3.6 |
| Ex. 23 | Sample 32 | 0.55 | 0.81 | 8.7 |
| Ex. 24 | Sample 33 | 0.54 | 0.92 | 8.5 |
| Ex. 25 | Sample 34 | 0.053 | 1.08 | 8.1 |
| Comp. Ex. 10 | Sample 35 | 0.56 | 2.8 | 3.1 |
| Comp. Ex. 11 | Sample 36 | 0.053 | 3.6 | 3 |
| Ex. 26 | Sample 37 | 0.05 | 0.98 | 8.2 |
| Ex. 27 | Sample 38 | 0.049 | 0.95 | 8.3 |
| Ex. 28 | Sample 39 | 0.051 | 0.99 | 8.2 |
| Comp. Ex. 12 | Sample 40 | 0.052 | 2.3 | 3.6 |
| Comp. Ex. 13 | Sample 41 | 0.05 | 4 | 2.7 |
| Ex. 29 | Sample 42 | 0.042 | 1.07 | 8.1 |
| Ex. 30 | Sample 43 | 0.042 | 0.95 | 8.3 |
| Ex. 31 | Sample 44 | 0.48 | 1 | 8 |
| Comp. Ex. 14 | Sample 45 | 0.065 | 2.5 | 3.3 |
| Ex. 32 | Sample 46 | 0.053 | 0.79 | 8.6 |
| Ex. 33 | Sample 47 | 0.052 | 0.78 | 8.7 |
| Ex. 34 | Sample 48 | 0.051 | 0.77 | 8.7 |
| Ex. 35 | Sample 49 | 0.05 | 0.75 | 8.9 |
| Ex. 36 | Sample 50 | 0.051 | 0.76 | 8.8 |
| Ex. 37 | Sample 51 | 0.051 | 0.76 | 8.8 |
| Ex. 38 | Sample 52 | 0.052 | 0.77 | 8.7 |
| Ex. 39 | Sample 53 | 0.053 | 0.78 | 8.7 |
| Ex. 40 | Sample 54 | 0.055 | 0.79 | 8.6 |
| Comp. Ex. 15 | Sample 55 | 0.045 | 3 | 3.5 |
| Comp. Ex. 16 | Sample 56 | 0.095 | 2.3 | 3.9 |

Samples 2 to 6, 8 to 13, 15 to 18, 21 to 24, 27 to 29, 32 to 34, 37 to 39, 42 to 44, and 46 to 54 each have a small VB, an Rz of 1.1 μm or smaller, and a cutting distance of 8 km or longer. This has revealed that these samples have excellent resistance to flank-face wear, resistance to crater wear, and resistance to boundary wear in the case of machining or the like of hardened steel in an environment having low equipment rigidity, low workpiece rigidity, or the like.

On the other hand, samples 1, 7, 14, 19, 20, 25, 26, 30, 31, 35, 36, 40, 41, 45, 55, and 56 each have an Rz of 2.2 μm or greater and a cutting distance of about 3 to 4 km. In these samples, therefore, peeling or chipping of the coating layer occurred in the case of machining or the like of hardened steel in an environment having low equipment rigidity, low workpiece rigidity, or the like. This has revealed that these samples have poor resistance to flank-face wear, resistance to crater wear, and resistance to boundary wear.

<Samples 4, 8, 55 and 56>

First, samples 8 and 56 are considered. Samples 8 and 56 are very similar in the composition and thickness of layer B, as well as the composition and the thickness of layer D. However, sample 8 includes layer A, while sample 56 does not include layer A. Sample 8 has an Rz of 1 μm or smaller and a cutting distance of 8.5 km or longer, while sample 56 has a VB about twice as high as that of sample 8 and an Rz more than twice as high as that of sample 8.

Next, samples 4 and 55 are considered. Samples 4 and 55 are very similar in the composition and thickness of layer A; however, sample 4 includes layer B, while sample 55 does not include layer B. Sample 4 has an Rz of 0.8 μm or smaller and a cutting distance of 9 km or longer, while sample 55 has an Rz (3.0 μm) more than twice as high as that of sample 4 and a cutting distance of about 3 to 4 km.

The foregoing has revealed that in the case of machining or the like of hardened steel in an environment having low equipment rigidity, low workpiece rigidity, or the like, a surface-coated boron nitride sintered body tool not including any one of layers A and B has poor resistance to flank-face wear, resistance to crater wear, and resistance to boundary wear. Surprisingly, however, a surface-coated boron nitride sintered body tool including both layers A and B is excellent in terms of all of resistance to flank-face wear, resistance to crater wear, and resistance to boundary wear, in the case of machining or the like of hardened steel in an environment having low equipment rigidity, low workpiece rigidity, or the like. This finding was made for the first time by the present inventors.

<Samples 1 to 7>

Samples 1 to 7 differ in the thickness of layer A. Samples 1 and 7 each have an Rz greater than 2.2 μm and a cutting distance of about 4 km. On the other hand, samples 2 to 6 each have an Rz of 1 μm or smaller and a cutting distance of 8 km or longer. From these facts, it has been revealed that when layer A has a thickness not less than 0.2 μm and not more than 10 μm, the resistance to flank-face wear, the resistance to crater wear, and the resistance to boundary wear of the surface-coated boron nitride sintered body tool are improved in the case of machining or the like of hardened steel in an environment having low equipment rigidity, low workpiece rigidity, or the like.

Furthermore, samples 2 to 5 each have an Rz of 0.8 μm or smaller and a cutting distance of 8.5 km or longer. Samples 3 and 4 each have an Rz of 0.75 μm or smaller and a cutting distance of 9 km or longer. From these facts, it has been revealed that layer A preferably has a thickness not less than 0.5 μm and not more than 5 μm, and more preferably not less than 1 μm and not more than 5 μm.

<Samples 8 to 13>

While samples 8 to 13 differ in the thickness of layer C, they each have an Rz of 1 μm or smaller and a cutting distance of 8.5 km or longer. Furthermore, samples 9 to 11 each have an Rz of 0.8 μm or smaller and a cutting distance of about 9 km. From these facts, it has been revealed that the thickness of layer C is preferably not less than 0.005 μm and not more than 0.5 μm, more preferably not less than 0.005 μm and not more than 0.2 μm, and even more preferably not less than 0.01 1 μm and not more than 0.2 μm.

<Samples 14 to 19>

Samples 14 to 19 differ in the composition of the B1a compound layers. Samples 14 and 19 each have an Rz greater than 2 μm and a cutting distance of about 4 km. On the other hand, samples 15 to 18 each have an Rz of 1 μm or smaller and a cutting distance of about 9 km. From these facts, it has been revealed that when the Si composition of the B1a compound layers is not less than 0.01 and not more than 0.25, the resistance to flank-face wear, the resistance to crater wear, and the resistance to boundary wear of the surface-coated boron nitride sintered body tool are improved, in the case of machining or the like of hardened steel in an environment having low equipment rigidity, low workpiece rigidity, or the like.

Furthermore, samples 16 to 18 each have an Rz of 0.8 $\mu$m or smaller and a cutting distance of about 9 km. Furthermore, samples 17 and 18 each have an Rz of 0.75 $\mu$m or smaller and a cutting distance of 9 km or longer. It has therefore been revealed that the Ti composition of the B1a compound layers is preferably not less than 0.7 and not more than 0.9, and more preferably not less than 0.75 and not more than 0.85. In other words, it has also been revealed that the Si composition of the B1a compound layers is preferably not less than 0.1 and not more than 0.25, and more preferably not less than 0.15 and not more than 0.25.

<Samples 20 to 25>

Samples 20 to 25 differ in the thickness of the B1a compound layers and the thickness of the B1b compound layers. Samples 20 to 25 each have an Rz greater than 2.2 $\mu$m and a cutting distance of about 3 to 4 km. On the other hand, samples 21 to 24 each have an Rz of 1.1 $\mu$m or smaller and a cutting distance of 7 km or longer. From these facts, it has been revealed that when each of the thickness of the B1a compound layers and the thickness of the B1b compound layers is not less than 0.5 nm and less than 30 nm, the resistance to flank-face wear, the resistance to crater wear, and the resistance to boundary wear of the surface-coated boron nitride sintered body tool are improved in the case of machining or the like of hardened steel in an environment having low equipment rigidity, low workpiece rigidity, or the like.

Furthermore, samples 21 to 23 each have an Rz of 1 $\mu$m or smaller and a cutting distance of 8 km or longer. Thus, the thickness of the B1a compound layers and the thickness of the Bib compound layers are each preferably not less than 1 nm and not more than 25 nm, more preferably not less than 1 nm and not more than 20 nm, and still more preferably not less than 1 nm and not more than 10 nm.

<Samples 26 to 30>

Samples 26 to 30 differ in the composition of each of the B1b compound layer and the B2 thin-film layer. Samples 26 and 30 each have an Rz of 3 $\mu$m or greater and a cutting distance of about 3 km. On the other hand, samples 27 to 29 each have an Rz of 1.1 $\mu$m or smaller and a cutting distance of 8 km or longer. From these facts, it has been revealed that when the Al composition of each of the B1b compound layer and the B2 thin-film layer is not less than 0.23 and not more than 0.8, the resistance to flank-face wear, the resistance to crater wear, and the resistance to boundary wear of the surface-coated boron nitride sintered body tool are improved, in the case of machining or the like of hardened steel in an environment having low equipment rigidity, low workpiece rigidity, or the like.

Furthermore, sample 28 has the smallest Rz and the longest cutting distance. It has therefore been revealed that the A1 composition of each of the B1b compound layer and the B2 thin-film layer is preferably not less than 0.5 and not more than 0.75, and more preferably not less than 0.6 and not more than 0.75.

<Samples 31 to 35>

Samples 31 to 35 differ in the thickness of the B1 thin-film layers. Samples 31 and 35 each have an Rz greater than 2.2 $\mu$m and a cutting distance of about 3 to 4 km. On the other hand, samples 32 to 34 each have an Rz of 1.1 $\mu$m or smaller and a cutting distance of 8 km or longer. From these facts, it has been revealed that when the thickness of the B1 thin-film layers is more than 30 nm and less than 200, the resistance to flank-face wear, the resistance to crater wear, and the resistance to boundary wear of the surface-coated boron nitride sintered body tool are improved in the case of machining or the like of hardened steel in an environment having low equipment rigidity, low workpiece rigidity, or the like.

Furthermore, samples 32 and 33 each have an Rz of 1 $\mu$m or smaller and a cutting distance of about 8.5 km. Therefore, it has also been revealed that the thickness of the B1 thin-film layers is preferably not less than 40 nm and not more than 180 nm, and more preferably not less than 40 nm and not more than 150 nm.

<Samples 36 to 40>

Samples 36 to 40 differ in the thickness of the B2 thin-film layers. Samples 36 and 40 each have an Rz greater than 2.2 $\mu$m and a cutting distance of about 3 to 4 km. On the other hand, samples 37 to 39 each have an Rz of 1 $\mu$m or smaller and a cutting distance of 8 km or longer. From these facts, it has been revealed that when the thickness of the B2 thin-film layers is more than 30 nm and less than 200, the resistance to flank-face wear, the resistance to crater wear, and the resistance to boundary wear of the surface-coated boron nitride sintered body tool are improved, in the case of machining or the like of hardened steel in an environment having low equipment rigidity, low workpiece rigidity, or the like.

Furthermore, sample 38 had the smallest Rz and the longest cutting distance. Therefore, it has also been revealed that the thickness of the B2 thin-film layers is preferably not less than 40 nm and not more than 180 nm, and more preferably not less than 40 nm and not more than 150 nm.

<Samples 41 to 45>

Since samples 41 to 45 differ in the number of B1 thin-film layers and the number of B2 thin-film layers, they differ in the thickness of layer B. Samples 41 and 45 each have an Rz of 2.5 $\mu$m or greater and a cutting distance of about 3 km. On the other hand, samples 42 to 44 each have an Rz of 1 about $\mu$m and a cutting distance of about 8 km. From these facts, it has been revealed that when the thickness of layer B is not less than 0.06 $\mu$m and not more than 5 $\mu$m, the resistance to flank-face wear, the resistance to crater wear, and the resistance to boundary wear of the surface-coated boron nitride sintered body tool are improved, in the case of machining or the like of hardened steel in an environment having low equipment rigidity, low workpiece rigidity, or the like.

Furthermore, sample 43 has the smallest Rz and the longest cutting distance. Therefore, it has also been revealed that the thickness of layer B is preferably not less than 0.1 $\mu$m and not more than 5 $\mu$m, and more preferably not less than 0.2 $\mu$m and not more than 3 $\mu$m.

<Samples 46 to 54>

While samples 46 to 54 differ in the composition of their cBN sintered body, they each have an Rz of 0.8 $\mu$m or smaller and a cutting distance of 8.5 km or longer. From these facts, it has been revealed that the volume content of the cubic boron nitride in the cubic boron nitride sintered body is preferably not less than 30% and not more than 85%.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

REFERENCE SIGNS LIST

3: base material; 10: coating layer; 20: layer D; 30: layer B; 31:B1 thin-film layer; 31 A: B1a compound layer; 31B: B1b compound layer; 32: B2 thin-film layer; 40: layer C; 50: layer A.

**Claims**

1. A surface-coated boron nitride sintered body tool in which at least a cutting edge portion comprises a cubic boron nitride sintered body and a coating layer formed on a surface of said cubic boron nitride sintered body,
said cubic boron nitride sintered body comprising not less than 30% and not more than 80% by volume of cubic boron nitride, and also comprising a binder phase containing an aluminum compound, an inevitable impurity, and at least one compound selected from the group consisting of a nitride, a carbide, a boride, and an oxide of a group 4 element, a group 5 element, and a group 6 element of a periodic table of elements, as well as a solid solution thereof,
said coating layer including a layer A and a layer B,
said layer A being composed of $MLa_{za1}$, where M represents one or more of Al, Si, as well as a group 4 element, a group 5 element, and a group 6 element of the periodic table of the elements; La represents one or more of B, C, N, and O; and za1 is not less than 0.85 and not more than 1.0,
said layer B being formed by alternately laminating one or more layers of each of two or more thin-film layers having different compositions,
each of said thin-film layers having a thickness more than 30 nm and less than 200 nm,
a B1 thin-film layer as one of said thin-film layers being formed by alternately laminating one or more layers of each of two or more compound layers having different compositions,
each of said compound layers having a thickness not less than 0.5 nm and less than 30 nm,
a B1a compound layer as one of said compound layers being composed of $(Ti_{1-xb1-yb1}Si_{xb1}M1_{yb1})(C_{1-zb1}N_{zb1})$, where M1 represents one or more of Al as well as a group 4 element, a group 5 element, and a group 6 element of the periodic table of the elements except for Ti; xb1 is not less than 0.01 and not more than 0.25; yb1 is not less than 0 and not more than 0.7; and zb1 is not less than 0.4 and not more than 1,
a B1b compound layer as one of said compound layers different from said B1a compound layer being composed of $(Al_{1-xb2}M2_{xb2})(C_{1-zb2}N_{zb2})$, where M2 represents one or more of Si as well as a group 4 element, a group 5 element, and a group 6 element of the periodic table of the elements; xb2 is not less than 0.2 and not more than 0.77; and zb2 is not less than 0.4 and not more than 1,
a B2 thin-film layer as one of said thin-film layers different from said B1 thin-film layer being composed of

$(Al_{1-xb3}M3_{xb3})(C_{1-zb3}N_{zb3})$, where M3 represents one or more of Si as well as a group 4 element, a group 5 element, and a group 6 element of the periodic table of the elements; xb3 is not less than 0.2 and not more than 0.77; and zb3 is not less than 0.4 and not more than 1,

said layer A having a thickness not less than 0.2 $\mu$m and not more than 10 $\mu$m,

said layer B having a thickness not less than 0.06 $\mu$m and not more than 5 $\mu$m, and

said coating layer having an overall thickness not less than 0.26 $\mu$m and not more than 15 $\mu$m.

2. The surface-coated boron nitride sintered body tool according to claim 1, wherein

said layer A is composed of $(Ti_{1-xa}Ma_{xa})(C_{1-za2}N_{za2})$, where Ma represents one or more of Al, Si, as well as a group 4 element, a group 5 element, and a group 6 element of the periodic table of the elements except for Ti; xa is not less than 0 and not more than 0.7; and za2 is not less than 0 and not more than 1.

3. The surface-coated boron nitride sintered body tool according to claim 2, wherein

in said layer A, the composition za2 of N changes in a step-like or slope-like manner toward a surface-side of said layer A from a cubic boron nitride sintered body-side.

4. The surface-coated boron nitride sintered body tool according to claim 2 or 3, wherein

said layer A has, on its surface-side, a region having a higher composition of C than on said cubic boron nitride sintered body-side.

5. The surface-coated boron nitride sintered body tool according to any of claims 1 to 4, wherein

said M2 represents at least one of Ti and Cr, and the composition xb2 of said M2 is not less than 0.25 and not more than 0.5.

6. The surface-coated boron nitride sintered body tool according to any of claims 1 to 5, wherein

said M3 represents at least one of Ti and Cr, and the composition xb3 of said M3 is not less than 0.25 and not more than 0.5.

7. The surface-coated boron nitride sintered body tool according to claim 6, wherein

said M3 represents an element identical to the element of said M2, and the composition xb3 of said M3 has a value identical to the value of the composition xb2 of said M2.

8. The surface-coated boron nitride sintered body tool according to any of claims 1 to 7, wherein

t2/t1, which is a ratio of an average thickness t2 of said B2 thin-film layer with respect to an average thickness t1 of said B1 thin-film layer, falls within $0.5 < t2/t1 \leq 10.0$.

9. The surface-coated boron nitride sintered body tool according to claim 8, wherein

said t2/t1 falls within $0.7 < t2/t1 \leq 5.0$.

10. The surface-coated boron nitride sintered body tool according to claim 8 or 9, wherein

said layer B is located nearer to a cubic boron nitride sintered body-side than said layer A, and

said t2/t1 falls within $1.1 < t2/t1 \leq 5.0$ on said cubic boron nitride sintered body-side, decreases toward said layer A, and falls within $0.7 < t2/t1 < 2$ on a layer A-side.

11. The surface-coated boron nitride sintered body tool according to any of claims 1 to 10, wherein

an average value of the Si composition in said layer B as a whole is not less than 0.003 and not more than 0.1.

12. The surface-coated boron nitride sintered body tool according to claim 11, wherein

the average value of the Si composition in said layer B as a whole is not less than 0.005 and not more than 0.07.

13. The surface-coated boron nitride sintered body tool according to any of claims 1 to 12, wherein

said layer A is located nearer to a surface-side of said surface-coated boron nitride sintered body tool than said layer B.

14. The surface-coated boron nitride sintered body tool according to any of claims 1 to 13, wherein

said coating layer further includes a layer C located between said layer A and said layer B,

said layer C is composed of $McLc_{zc}$, where Mc represents one or more of Al, Si, as well as a group 4 element, a group 5 element, and a group 6 element of the periodic table of the elements; Lc represents one or more of B, C, N, and O; and zc is not less than 0 and not more than 0.85, and

said layer C has a thickness not less than 0.005 $\mu$m and not more than 0.5 $\mu$m.

15. The surface-coated boron nitride sintered body tool according to claim 14, wherein
the composition zc of said Lc is more than 0 and less than 0.7.

16. The surface-coated boron nitride sintered body tool according to claim 14 or 15, wherein
said layer C includes at least one or more of elements forming said layer A and said layer B.

17. The surface-coated boron nitride sintered body tool according to any of claims 1 to 16, wherein
said coating layer further includes a layer D located between said cubic boron nitride sintered body and said layer B, and
said layer D is composed of $MdLd_{zd}$, where Md represents one or more of Al, Si, as well as a group 4 element, a group 5 element, and a group 6 element of the periodic table of the elements; Ld represents one or more of B, C, N, and O; and zd is not less than 0.85 and not more than 1.

18. The surface-coated boron nitride sintered body tool according to any of claims 1 to 17, wherein
said cubic boron nitride sintered body contains not less than 50% and not more than 65% by volume of said cubic boron nitride.

19. The surface-coated boron nitride sintered body tool according to any of claims 1 to 18, wherein
at an interface between said cubic boron nitride sintered body and said coating layer,
particles made of said cubic boron nitride protrude more toward said coating layer than said binder phase, and
there is a difference in level of not less than 0.05 $\mu$m and not more than 1.0 $\mu$m between the particles of said cubic boron nitride and said binder phase.

20. The surface-coated boron nitride sintered body tool according to any of claims 1 to 19, wherein
a volume content of said cubic boron nitride in said cubic boron nitride sintered body increases toward the inside of said cubic boron nitride sintered body from the interface between said cubic boron nitride sintered body and said coating layer.

21. The surface-coated boron nitride sintered body tool according to any of claims 1 to 20, wherein
a particle size of said cubic boron nitride contained in said cubic boron nitride sintered body increases toward the inside of said cubic boron nitride sintered body from the interface between said cubic boron nitride sintered body and said coating layer.

**Amended claims under Art. 19.1 PCT**

1. (Amended) A surface-coated boron nitride sintered body tool in which at least a cutting edge portion comprises a cubic boron nitride sintered body and a coating layer formed on a surface of said cubic boron nitride sintered body, said cubic boron nitride sintered body comprising not less than 30% and not more than 80% by volume of cubic boron nitride, and also comprising a binder phase containing an aluminum compound, an inevitable impurity, and at least one compound selected from the group consisting of a nitride, a carbide, a boride, and an oxide of a group 4 element, a group 5 element, and a group 6 element of a periodic table of elements, as well as a solid solution thereof, said coating layer including a layer A and a layer B,
said layer A being composed of $MLa_{za1}$, where M represents one or more of Al, Si, as well as a group 4 element, a group 5 element, and a group 6 element of the periodic table of the elements; La represents one or more of B, C, N, and O; and za1 is not less than 0.85 and not more than 1.0,
said layer B being formed by alternately laminating one or more layers of each of two or more thin-film layers having different compositions,
each of said thin-film layers having a thickness more than 30 nm and less than 200 nm,
a B1 thin-film layer as one of said thin-film layers being formed by alternately laminating one or more layers of each of two or more compound layers having different compositions,
each of said compound layers having a thickness not less than 0.5 nm and less than 30 nm,
a B1a compound layer as one of said compound layers being composed of $(Ti_{1-xb1-yb1}Si_{xb1}Ml_{yb1})(C_{1-zb}]N_{zb1})$, where M1 represents one or more of Al as well as a group 4 element, a group 5 element, and a group 6 element of the periodic table of the elements except for Ti; xb1 is not less than 0.01 and not more than 0.25; yb1 is not less than 0 and not more than 0.7; and zb1 is not less than 0.4 and not more than 1,

a B1b compound layer as one of said compound layers different from said B1a compound layer being composed of $(Al_{1-xb2}M2_{xb2})(C_{1-zb2}N_{zb2})$, where M2 represents one or more of Si as well as a group 4 element, a group 5 element, and a group 6 element of the periodic table of the elements; xb2 is not less than 0.2 and not more than 0.77; and zb2 is not less than 0.4 and not more than 1,

a B2 thin-film layer as one of said thin-film layers different from said B1 thin-film layer being composed of $(Al_{1-xb3}M3_{xb3})(C_{1-zb3}N_{zb3})$, where M3 represents one or more of Si as well as a group 4 element, a group 5 element, and a group 6 element of the periodic table of the elements; xb3 is not less than 0.2 and not more than 0.77; and zb3 is not less than 0.4 and not more than 1,

said layer A having a thickness not less than 0.2 $\mu$m and not more than 10 $\mu$m,

said layer B having a thickness not less than 0.06 $\mu$m and not more than 5 $\mu$m,

said coating layer having an overall thickness not less than 0.26 $\mu$m and not more than 15 $\mu$m,

<u>at an interface between said cubic boron nitride sintered body and said coating layer,</u>

<u>particles made of said cubic boron nitride protruding more toward said coating layer than said binder phase, and there being a difference in level of not less than 0.05 $\mu$m and not more than 1.0 $\mu$m between the particles of said cubic boron nitride and said binder phase.</u>

**2.** The surface-coated boron nitride sintered body tool according to claim 1, wherein

said layer A is composed of $(Ti_{1-xa}Ma_{xa})(C_{1-za2}N_{za2})$, where Ma represents one or more of Al, Si, as well as a group 4 element, a group 5 element, and a group 6 element of the periodic table of the elements except for Ti; xa is not less than 0 and not more than 0.7; and za2 is not less than 0 and not more than 1.

**3.** The surface-coated boron nitride sintered body tool according to claim 2, wherein

in said layer A, the composition za2 of N changes in a step-like or slope-like manner toward a surface-side of said layer A from a cubic boron nitride sintered body-side.

**4.** The surface-coated boron nitride sintered body tool according to claim 2 or 3, wherein

said layer A has, on its surface-side, a region having a higher composition of C than on said cubic boron nitride sintered body-side.

**5.** The surface-coated boron nitride sintered body tool according to any of claims 1 to 4, wherein

said M2 represents at least one of Ti and Cr, and the composition xb2 of said M2 is not less than 0.25 and not more than 0.5.

**6.** The surface-coated boron nitride sintered body tool according to any of claims 1 to 5, wherein

said M3 represents at least one of Ti and Cr, and the composition xb3 of said M3 is not less than 0.25 and not more than 0.5.

**7.** The surface-coated boron nitride sintered body tool according to claim 6, wherein

said M3 represents an element identical to the element of said M2, and the composition xb3 of said M3 has a value identical to the value of the composition xb2 of said M2.

**8.** The surface-coated boron nitride sintered body tool according to any of claims 1 to 7, wherein

t2/t1, which is a ratio of an average thickness t2 of said B2 thin-film layer with respect to an average thickness t1 of said B1 thin-film layer, falls within $0.5 < t2/t1 \leq 10.0$.

**9.** The surface-coated boron nitride sintered body tool according to claim 8, wherein

said t2/t1 falls within $0.7 < t2/t1 \leq 5.0$.

**10.** The surface-coated boron nitride sintered body tool according to claim 8 or 9, wherein

said layer B is located nearer to a cubic boron nitride sintered body-side than said layer A, and

said t2/t1 falls within $1.1 < t2/t1 \leq 5.0$ on said cubic boron nitride sintered body-side, decreases toward said layer A, and falls within $0.7 < t2/t1 < 2$ on a layer A-side.

**11.** The surface-coated boron nitride sintered body tool according to any of claims 1 to 10, wherein

an average value of the Si composition in said layer B as a whole is not less than 0.003 and not more than 0.1.

**12.** The surface-coated boron nitride sintered body tool according to claim 11, wherein

the average value of the Si composition in said layer B as a whole is not less than 0.005 and not more than 0.07.

**13.** The surface-coated boron nitride sintered body tool according to any of claims 1 to 12, wherein
said layer A is located nearer to a surface-side of said surface-coated boron nitride sintered body tool than said layer B.

**14.** The surface-coated boron nitride sintered body tool according to any of claims 1 to 13, wherein
said coating layer further includes a layer C located between said layer A and said layer B,
said layer C is composed of $McLc_{zc}$, where Mc represents one or more of Al, Si, as well as a group 4 element, a group 5 element, and a group 6 element of the periodic table of the elements; Lc represents one or more of B, C, N, and O; and zc is not less than 0 and not more than 0.85, and
said layer C has a thickness not less than 0.005 $\mu$m and not more than 0.5 $\mu$m.

**15.** The surface-coated boron nitride sintered body tool according to claim 14, wherein
the composition zc of said Lc is more than 0 and less than 0.7.

**16.** The surface-coated boron nitride sintered body tool according to claim 14 or 15, wherein
said layer C includes at least one or more of elements forming said layer A and said layer B.

**17.** The surface-coated boron nitride sintered body tool according to any of claims 1 to 16, wherein
said coating layer further includes a layer D located between said cubic boron nitride sintered body and said layer B, and
said layer D is composed of $MdLd_{zd}$, where Md represents one or more of Al, Si, as well as a group 4 element, a group 5 element, and a group 6 element of the periodic table of the elements; Ld represents one or more of B, C, N, and O; and zd is not less than 0.85 and not more than 1.

**18.** The surface-coated boron nitride sintered body tool according to any of claims 1 to 17, wherein
said cubic boron nitride sintered body contains not less than 50% and not more than 65% by volume of said cubic boron nitride.

**19.** (Canceled)

**20.** (Amended) The surface-coated boron nitride sintered body tool according to any of claims 1 to 18, wherein
a volume content of said cubic boron nitride in said cubic boron nitride sintered body increases toward the inside of said cubic boron nitride sintered body from the interface between said cubic boron nitride sintered body and said coating layer.

**21.** (Amended) The surface-coated boron nitride sintered body tool according to any of claims 1 to 18 and 20, wherein
a particle size of said cubic boron nitride contained in said cubic boron nitride sintered body increases toward the inside of said cubic boron nitride sintered body from the interface between said cubic boron nitride sintered body and said coating layer.

FIG.1

FIG.2

## INTERNATIONAL SEARCH REPORT

| International application No. |
| --- |
| PCT/JP2014/054685 |

A.  CLASSIFICATION OF SUBJECT MATTER
*B23B27/14*(2006.01)i, *B23B27/20*(2006.01)i, *C23C14/06*(2006.01)i

According to International Patent Classification (IPC) or to both national classification and IPC

B.  FIELDS SEARCHED

Minimum documentation searched (classification system followed by classification symbols)
B23B27/14, B23B27/20, C23C14/06

Documentation searched other than minimum documentation to the extent that such documents are included in the fields searched
Jitsuyo Shinan Koho        1922-1996    Jitsuyo Shinan Toroku Koho   1996-2014
Kokai Jitsuyo Shinan Koho   1971-2014    Toroku Jitsuyo Shinan Koho   1994-2014

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X | WO 2012/005275 A1  (Tungaloy Corp.), 12 January 2012 (12.01.2012), | 1-9,11-14, 16,18 |
| A | table 4, base materials 1, 6; table 6, comparative product 5; paragraph [0019] (page 8, lines 22 to 25) & US 2013/0108850 A1    & EP 2591869 A1 | 10,15,17, 19-21 |
| A | WO 2010/140959 A1  (SECO TOOLS AB), 09 December 2010 (09.12.2010), entire text; all drawings & JP 2012-528733 A      & US 2012/0114437 A1 | 1-21 |
| A | WO 2010/150335 A1  (Tungaloy Corp.), 29 December 2010 (29.12.2010), entire text; all drawings & US 2012/0090247 A1    & EP 2446987 A1 | 1-21 |

[X]  Further documents are listed in the continuation of Box C.          [ ]  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 12 May, 2014 (12.05.14) | 20 May, 2014 (20.05.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

International application No.

PCT/JP2014/054685

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2006-137982 A  (Hitachi Tool Engineering Ltd.), 01 June 2006 (01.06.2006), entire text; all drawings (Family: none) | 1-21 |
| A | JP 2011-83879 A  (Sumitomo Electric Hardmetal Corp.), 28 April 2011 (28.04.2011), entire text; all drawings (Family: none) | 1-21 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010150335 A
- WO 2012005275 A

- JP 2008188689 A
- JP 2008534297 A